(19)

Europäisches
Patentamt
European
Patent Office
Office européen
des brevets

(11) **EP 2 911 304 A1**

(12) **EUROPEAN PATENT APPLICATION**

(43) Date of publication:
**26.08.2015 Bulletin 2015/35**

(51) Int Cl.:
**H03M 13/11** *(2006.01)*

(21) Application number: **14305248.8**

(22) Date of filing: **24.02.2014**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**

(71) Applicant: **ALCATEL LUCENT
92100 Boulogne-Billancourt (FR)**

(72) Inventors:
• **Schmalen, Laurent
70435 Stuttgart (DE)**

• **Leven, Andreas B.
70435 Stuttgart (DE)**

(74) Representative: **2SPL Patentanwälte PartG mbB
Postfach 15 17 23
80050 München (DE)**

Remarks:
Amended claims in accordance with Rule 137(2)
EPC.

(54) **Sliding window decoding of LDPC convolutional codes (LDPC-CC)**

(57)     Embodiments relate to a concept for sliding window decoding a signal which is encoded with an LDPC convolutional code having a parity check matrix. A new frame (1030) of reliability information of the encoded signal is provided (902) to an input portion (1012-I) of a window (1012) of reliability information. A number of decoding iterations is executed (904) using a part of the parity check matrix and the window (1012) of reliability information. If a frame (1254) of reliability information in an output portion (1012-O) of the window (1012) of reliability information has been correctly decoded, said frame (1254) is forwarded from the output portion (1012-O) to a hard decision entity, the remaining frames of reliability information are shifted in the window (1012) toward the output portion (1012-O), and a new frame (1030) of reliability information of the encoded signal is provided (902) to the input portion (1012-I) of the decoding window (1012).

Fig. 9

**EP 2 911 304 A1**

## Description

Embodiments of the present disclosure relate to communication systems and, more particularly, to communication systems employing Low-Density Parity-Check (LDPC) codes.

## Background

This section introduces aspects that may be helpful in facilitating a better understanding of the inventions. Accordingly, the statements of this section are to be read in this light and are not to be understood as admissions about what is in the prior art or what is not in the prior art.

A Low-Density Parity-Check (LDPC) code is a linear error correcting code for transmitting a message over a noisy transmission channel. It may be constructed using a sparse bipartite graph whose vertices can be divided into two disjoint independent sets $U$ and $V$ such that every edge connects a vertex in $U$ to one in $V$. Examples of bipartite graphs used for LPDC codes are the so-called Tanner graph or graph prototypes (protographs). In coding theory, bipartite graphs may be used to construct longer codes from smaller ones. Both LPDC encoders and LPDC decoders may employ these graphs extensively.

A possible application of LDPC codes is in optical or wireless communication systems. As the LDPC codes used in optical communications are mainly high-rate LDPC codes with rates higher than 0.8 (overhead smaller than 25%), these LDPC codes are usually based on parity check matrices of size $M$ (rows) $\times N$ (columns), with M << N.

In the last few years, the class of spatially coupled code ensembles has emerged and has shown to have appealing properties. LDPC convolutional codes, which are one particular instance of spatially coupled codes, have been around for more than a decade, but only recently it has been noticed that the belief propagation thresholds of certain (terminated) protograph-based LDPC convolutional codes approach the Maximum A-Posteriori (MAP) thresholds of the underlying ensemble. Analogous to LDPC block codes, LDPC convolutional codes may be defined by sparse parity-check matrices, which allow them to be decoded using iterative message-passing algorithms.

## Summary

Some simplifications may be made in the following summary, which is intended to highlight and introduce some aspects of the various exemplary embodiments, but such simplifications are not intended to limit the scope of embodiments. Detailed descriptions of a preferred exemplary embodiment adequate to allow those of ordinary skill in the art to make and use the inventive concepts will follow in later sections.

According to one aspect of the present disclosure it is provided a method for decoding an encoded signal. The encoded signal is encoded with an LDPC convolutional code having a parity check matrix. The method comprises

    a) providing a new frame of reliability information of the encoded signal to an input portion of a window of reliability information;

    b) executing a number of decoding iterations using a part of the parity check matrix corresponding to the window of reliability information; and if a frame of reliability information in an output portion of the window of reliability information has been correctly decoded,

    c) forwarding said frame from the output portion to a hard decision entity, shifting the remaining frames of reliability information in the window toward the output portion, and returning to act a).

In an example embodiment, act c) is not performed, if the frame of reliability information in the window's output portion has not been decoded correctly. Instead, an additional number of decoding iterations may be performed using the part of the parity check matrix and the same window of reliability information.

According to a further aspect of the present disclosure it is provided an apparatus for decoding an encoded signal. The encoded signal is encoded with an LDPC convolutional code having a parity check matrix. The apparatus includes a windowed decoder and a control unit. The control unit is configured to provide a new frame of reliability information of the encoded signal to an input portion of a window of reliability information. The windowed decoder is configured to execute a number of decoding iterations using the part of the parity check matrix and the window of reliability information. The control unit is configured to determine whether a frame of reliability information in an output portion of the window has been correctly decoded. If the frame in the output portion has been correctly decoded, the control unit causes forwarding said frame from the output portion to a hard decision entity, shifting the remaining frames of reliability information in the window toward the output portion, and providing a new frame of reliability information into the input portion of the window.

If the frame of reliability information in the output portion of the window has not been decoded correctly, the control unit may be configured to keep said frame in the output portion and to cause an additional number of decoding iterations using the part of the parity check matrix and the same window of reliability information, according to an example embodiment,.

Some embodiments comprise digital circuitry installed within the apparatus for performing the respective acts. Such a digital control circuitry, e.g., a Digital Signal Processor (DSP), a Field-Programmable Gate Array (FPGA), an Application-Specific Integrated Circuit (ASIC), or a general purpose processor may be coupled to memory circuitry and needs to be configured accordingly by hardware and/or software. In example embodiments, the (decoding) window is implemented by means of the memory circuitry. Hence, yet further embodiments also provide a computer program having a program code for performing embodiments of the method, when the computer program is executed on a computer or a programmable hardware device.

Embodiments may allow improving the coding gain of a spatially coupled code with complexity and iteration constrained windowed decoding without significantly increasing hardware requirements and complexity. Embodiments are potentially also beneficial if channels with varying quality are employed where embodiments allows to better compensate for short bursts of errors by executing more effective iterations to these parts. Potentially, embodiments may permit to lower the error floor by correcting error patterns that cannot be recovered by conventional decoders.

Brief description of the Figures

Some embodiments of apparatuses and/or methods will be described in the following by way of example only, and with reference to the accompanying figures, in which

Fig. 1     illustrates block diagram of a conventional row-layered LDPC decoding algorithm;

Fig. 2     illustrates an example of a copy-and-permute operation for a protograph-based LDPC code using a protomatrix **B**;

Fig. 3     shows a visualization of a parity check matrix **H** obtained by lifting of the lifting matrix **A** obtained from the protograph shown in Fig. 2;

Fig. 4     shows a protograph-based code design for Spatially-Coupled Codes and its corresponding protograph matrix **B**;

Fig. 5     illustrates a quasi-cyclic parity-check matrix corresponding to the protograph in Fig. 4. Obtained via double lifting with P=8 and S=512;

Fig. 6     illustrates a system model with a spatially coupled encoder;

Fig. 7     shows four phases of windowed decoding of spatially coupled LDPC convolutional codes;

Fig. 8     shows a flowchart of an example embodiment of a method for decoding an LDPC convolutional encoded signal;

Fig. 9     illustrates a decoder architecture comprising a modified windowed decoder, two FIFO buffers and a control unit;

Fig. 10    illustrates a decoder with combined ingress and egress FIFO with variable read locations;

Fig. 11    illustrates a decoder architecture with soft ingress FIFO and binary egress FIFO;

Fig. 12    shows a possible flowchart for implementing a control unit; and

Figs. 13a  illustrates a performance comparison for Code $C_1$ with V = 1; and

Fig. 13b   illustrates a performance comparison for Code $C_2$ with V = 1 and V = 2

Description of Embodiments

Various example embodiments will now be described more fully with reference to the accompanying drawings in which some example embodiments are illustrated.

Accordingly, while example embodiments are capable of various modifications and alternative forms, embodiments thereof are shown by way of example in the drawings and will herein be described in detail. It should be understood, however, that there is no intent to limit example embodiments to the particular forms disclosed, but on the contrary, example embodiments are to cover all modifications, equivalents, and alternatives falling within the scope of the claims. Like numbers refer to like elements throughout the description of the figures. It will be understood that, although the terms first, second, etc. may be used herein to describe various elements, these elements should not be limited by these terms. These terms are only used to distinguish one element from another. For example, a first element could be termed a second element, and, similarly, a second element could be termed a first element, without departing from the scope of example embodiments. As used herein, the term "and/or" includes any and all combinations of one or more of the associated listed items.

It will be understood that when an element is referred to as being "connected" or "coupled" to another element, it can be directly connected or coupled to the other element or intervening elements may be present. In contrast, when an element is referred to as being "directly connected" or "directly coupled" to another element, there are no intervening elements present. Other words used to describe the relationship between elements should be interpreted in a like fashion (e.g., "between" versus "directly between," "adjacent" versus "directly adjacent," etc.).

The terminology used herein is for the purpose of describing particular embodiments only and is not intended to be limiting of example embodiments. As used herein, the singular forms "a," "an" and "the" are intended to include the plural forms as well, unless the context clearly indicates otherwise. It will be further understood that the terms "comprises," "comprising," "includes" and/ or "including," when used herein, specify the presence of stated features, integers, steps, operations, elements and/or components, but do not preclude the presence or addition of one or more other features, integers, steps, operations, elements, components and/ or group thereof.

It should also be noted that in some alternative implementations, the functions/ acts noted may occur out of the order noted in the figures. For example, two figures shown in succession may in fact be executed substantially concurrently or may sometimes be executed in the reverse order, depending upon the functionality/acts involved.

Unless otherwise defined, all terms (including technical and scientific terms) used herein have the same meaning as commonly understood by one of ordinary skill in the art to which example embodiments belong. It will be further understood that terms, e.g., those defined in commonly used dictionaries, should be interpreted as having a meaning that is consistent with their meaning in the context of the relevant art and will not be interpreted in an idealized or overly formal sense unless expressly so defined herein.

Portions of example embodiments and corresponding detailed description are presented in terms of software, or algorithms and symbolic representations of operation of data bits within a computer memory. These descriptions and representations are the ones by which those of ordinary skill in the art effectively convey the substance of their work to others of ordinary skill in the art. An algorithm, as the term is used here, and as it is used generally, is conceived to be a self-consistent sequence of steps leading to a desired result. The steps are those requiring physical manipulations of physical quantities. Usually, though not necessarily, these quantities take the form of optical, electrical, or magnetic signals capable of being stored, transferred, combined, compared, and otherwise manipulated. It has proven convenient at times, principally for reasons of common usage, to refer to these signals as bits, values, elements, symbols, characters, terms, numbers, or the like.

In the following description, illustrative embodiments will be described with reference to acts and symbolic representations of operations (e.g., in the form of flowcharts) that may be implemented as program modules or functional processes including routines, programs, objects, components, data structures, etc., that perform particular tasks or implement particular abstract data types and may be implemented using existing hardware at existing network elements or control nodes. Such existing hardware may include one or more Central Processing Units (CPUs), Digital Signal Processors (DSPs), Application-Specific Integrated Circuits, Field Programmable Gate Arrays (FPGAs), computers, or the like.

Unless specifically stated otherwise, or as is apparent from the discussion, terms such as "processing" or "computing" or "calculating" or "determining" or "displaying" or the like, refer to the action and processes of a computer system, or similar electronic computing device, that manipulates and transforms data represented as physical, electronic quantities within the computer system's registers and memories into other data similarly represented as physical quantities within the computer system memories or registers or other such information storage, transmission or display devices.

As disclosed herein, the term "storage medium", "storage unit" or "computer readable storage medium" may represent one or more devices for storing data, including Read Only Memory (ROM), Random Access Memory (RAM), magnetic RAM, core memory, magnetic disk storage mediums, optical storage mediums, flash memory devices and/ or other tangible machine readable mediums for storing information. The term "computer-readable medium" may include, but is not limited to, portable or fixed storage devices, optical storage devices, and various other mediums capable of storing, containing or carrying instruction(s) and/or data.

Furthermore, example embodiments may be implemented by hardware, software, firmware, middleware, microcode, hardware description languages, or any combination thereof. When implemented in software, firmware, middleware or microcode, the program code or code segments to perform the necessary tasks may be stored in a machine or computer readable medium such as a computer readable storage medium. When implemented in software, a processor or processors will perform the necessary tasks.

A code segment may represent a procedure, function, subprogram, program, routine, subroutine, module, software package, class, or any combination of instructions, data structures or program statements. A code segment may be coupled to another code segment or a hardware circuit by passing and /or receiving information, data, arguments, parameters or memory contents. Information, arguments, parameters, data, etc. may be passed, forwarded, or transmitted via any suitable means including memory sharing, message passing, token passing, network transmission, etc.

For a better understanding of embodiments, a short introduction to LDPC codes and some related decoding algorithms will be provided in the following.

An LDPC code may be defined by a sparse parity-check matrix **H** of dimension $M \times N$, where $N$ is the LDPC code word length (e.g., in bits) of the LDPC code and $M$ denotes the number of parity bits or symbols. The rows of a parity check matrix are parity checks on the code words of a code. That is, they show how linear combinations of certain digits of each code word equal zero. Usually, the number of information symbols equals $N$-$M$ (but can be larger, depending on the rank of the parity-check matrix **H**). The design rate of the code amounts to $r = (N$-$M)/N$. The overhead of the code is defined as OH = $1/r$ - 1 = $M/(N$-$M)$. Sparse means that the number of 1s in **H** is small compared to the number of zero entries. Practical LDPC codes usually have a fraction of "1s" that is below 1% by several orders of magnitude.

We start by introducing some notation and terminology related to LDPC codes. Each column of the parity check matrix **H** corresponds to one symbol (e.g. a bit) of a Forward Error Correction (FEC) frame or LPDC code word. As LDPC codes can also be represented in a graphical structure called Tanner graph, the columns of **H** and thus the FEC frame (LPDC code word) symbols are sometimes also referred to as variable nodes, referring to the graph-theoretic representation. Similarly, each row of **H** corresponds to a parity check equation and ideally defines a parity symbol (e.g., a parity bit), if **H** has full rank. For example, the rank can be defined as the column rank. The column rank of a matrix **H** is the maximum number of linearly independent column vectors of **H.** Correspondingly, the row rank of **H** is the maximum number of linearly independent row vectors of **H.** Owing to the Tanner graph representation, the rows of **H** are associated to so-called check nodes, and the columns of **H** are associated to so-called variable nodes. Further, the $M$ rows of **H** specify $M$ check node connections, and the $N$ columns of **H** specify $N$ variable node connections. Thereby, check node $i$ is connected to variable node $j$ whenever element $H_{i,j}$ in **H** is different from zero. Note that the row rank and the column rank of a matrix **H** are always equal, which is a well-known result in linear algebra.

In order to describe an exemplary LDPC decoder we introduce some additional notation. First, we denote by x a vector of $K = N$ - $M$ information symbols. The single elements of **x** are denoted by $x_i$, i.e., $\mathbf{x} = (x_1, x_2, ..., x_i, ..., x_K)^T$. After encoding with an exemplary LDPC encoder, an LDPC code word $\mathbf{y} = (y_1, y_2, ..., y_N)^T$ of length $N$ results. We denote by $y_i$ the single elements of the code word **y**. The LDPC code is said to be systematic if the information vector **x** is included in the code word, e.g., if (after possible rearrangement) $\mathbf{y} = (x_1,..., x_K, p_1, ... p_M)^T$, with $\mathbf{p} = (p_1, ..., p_M)^T$ denoting the vector of $M$ parity symbols. Furthermore, let the set $\mathcal{N}$ ($m$) denote the positions of the 1s in the $m$-th row of **H,** i.e., $\mathcal{N}$ ($m$) = {$i$: $H_{m,i}$ = 1}. A binary vector **y** is a code word of the LDPC code defined by **H,** if **Hy** = **0**, with the additions defined over the binary field (addition modulo-2, or XOR, respectively), for example. The set of code words is thus defined to be the null space of **H**. This signifies that the product of each row of **H** and **y** is zero, or $\sum_{j \in \mathcal{N}(m)} y_j = 0,$ for all $m$ with $1 \le m \le M$.

Let us illustrate the concept of LDPC codes by a "toy" example. This example defines a binary parity check matrix **H** of two concatenated (4, 5) single parity check codes, separated by a 4x5 block-interleaver. The exemplary parity check matrix **H** of dimension 9x25 is given by

$$\mathbf{H} = \begin{pmatrix} 1 & 1 & 1 & 1 & & & & & & & & & & & & & & & & & 1 & & & & \\ & & & & 1 & 1 & 1 & 1 & & & & & & & & & & & & & & 1 & & & \\ & & & & & & & & 1 & 1 & 1 & 1 & & & & & & & & & & & 1 & & \\ & & & & & & & & & & & & 1 & 1 & 1 & 1 & & & & & & & & 1 & \\ 1 & & & & & 1 & & & & 1 & & & & 1 & & & & & & & 1 & & & & \\ & 1 & & & & & 1 & & & & 1 & & & & 1 & & & & & & & 1 & & & \\ & & 1 & & & & & 1 & & & & 1 & & & & 1 & & & & & & & 1 & & \\ & & & 1 & & & & & 1 & & & & 1 & & & & & & & & & & & 1 & \\ & & & & & & & & & & & & & & & & 1 & 1 & 1 & 1 & & & & & 1 \end{pmatrix}.$$

Note that for simplicity reasons only the 1s are illustrated in the parity check matrix **H** above. Thus, M= 9, N= 25, and the code has an overhead of 56% (given by $M/(N-M)$) or a rate of $r = 0.64$, equivalently. We have $\mathcal{N}$ (1) = {1; 2; 3; 4; 17}, $\mathcal{N}$ (2) = {5; 6; 7; 8; 18}, $\mathcal{N}$ (3) = {9; 10; 11; 12; 19}, $\mathcal{N}$ (4) = {13; 14; 15; 16; 20}, $\mathcal{N}$ (5) = {1; 5; 9; 13; 21}, $\mathcal{N}$ (6) = {2; 6; 10; 14; 22}, $\mathcal{N}$ (7) = {3; 7; 11; 15; 23}, $\mathcal{N}$ (8) = {4; 8; 12; 16; 24}, $\mathcal{N}$ (9) = {17; 18; 19; 20; 25}. This means for instance that we have (using the first row of **H**) $y_1+y_2+y_3+y_4+y_{17}=0$, or, if the code is systematic, $x_1+x_2+x_3+x_4+p_1=0$, i.e., $p_1=x_1+x_2+x_3+x_4$, defines the first parity bit.

One common decoding algorithm for LDPC codes is the so-called "sum-product" decoding algorithm and its simplified versions. These algorithms can be described either in a graph structure commonly denoted Tanner graph, or given directly in a form suitable for implementation. While the former is advantageous for describing and understanding the underlying operations, we focus on the latter.

In the context of coherent detection, we can usually assume an equivalent Additive White Gaussian Noise (AWGN) channel model for the transmission channel. This assumption is justified by the central limit theorem which applies due to the extensive use of filtering in inner Digital Signal Processing (DSP) stages of a transmitter and/or receiver. If we denote by $y_i$ ($i$ = 1, ..., $N$) the single bits of an LDPC code word **y** as defined above, then the received values at the input of an LDPC decoder amount to $z_i = y_i + n_i$, with $n_i$ ($i$ = 1, ..., $N$) being Gaussian distributed noise samples of zero mean and variance $\sigma^2$. Usually, the received noisy samples are converted into the Log-Likelihood Ratio (LLR) domain, which leads to a numerically more stable decoder implementation. The LLR of a received sample $z_i$ may be defined as

$$L(z_i) = \log\left( \frac{p(z_i \mid y_i = 0)}{p(z_i \mid y_i = 1)} \right) \qquad (1)$$

with $p(z_i \mid y_i = k) = \exp\left(- (z_i - (1-2k))^2 / (2\sigma^2)\right) / \sqrt{2\pi\sigma^2}$ denoting the probability density function (pdf) of the received sample $z_i$ under AWGN assumption conditioned on the transmitted bit $y_i$ and with bipolar signaling ($y_i$=0 $\rightarrow$ +1, $y_i$=1 $\rightarrow$ -1). Conveniently, it turns out that $L(z_i) = z_i \cdot 2/\sigma^2 = z_i \cdot L_c$ under the AWGN assumption. Usually, the value $L_c = 2/\sigma^2$ is assumed to be constant and predetermined.

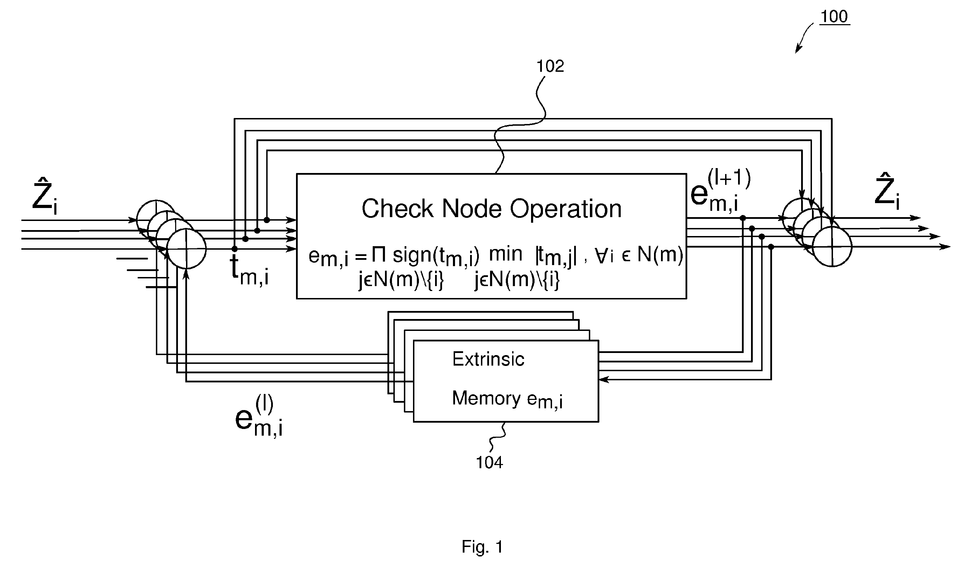

Turning now to **Fig. 1,** we describe a conventional row-layered LDPC decoding algorithm. Here, a LDPC decoder 100 continuously updates the received LLR values with the goal to compute LLRs that approximate the Maximum A-Posteriori (MAP) values. The received vector of LLRs z is therefore copied to a memory **z** of size N, which is continuously updated. This memory maybe referred to as LLR memory, a-posteriori memory or reliability information memory in later sections of this specification. The decoding operation in the row-layered decoder 100 comprises three acts, where a) the first act prepares the input data, b) the second act performs the computation of new extrinsic data and act c) updates the LLR memory. The row-layered LDPC decoder 100 may carry out the three steps sequentially for each row of the parity check matrix **H.** After all rows have been considered, a single decoding iteration has been carried out. The LDPC decoder 100 usually carries out several iterations, where the number depends on the available resources.

In the following, we describe the aforementioned three acts for a single row $m$ of **H.** The first step a) comprises

computing card( $\mathcal{N}$ (m)) = $d_c$ (card = cardinality) temporary values $t_{m,i}$, with

$$ t_{m,i} = \hat{z}_i - e_{m,i}^{(l)} \qquad \text{for all } i \in \mathcal{N}(m) \qquad (2) $$

for all non-zero entries (indexed by $i$) of the $m$'th row of H. The superscript$^{(l)}$ denotes the iteration counter, i.e., the operations are carried out in the $l$-th iteration of the row-layered LDPC decoding procedure. The value $e_{m,i}$ is the (stored) extrinsic memory for row m and variable $\hat{z}_i$. At the beginning of the decoding of a single LDPC frame (code word), all $e_{m,i}$ may be initialized by zero $\left(\text{i.e., } e_{m,i}^{(1)} = 0\right)$ and then continuously updated. Note that in total only $\Sigma_m$ card( $\mathcal{N}$ (m)) memory locations may be used for storing the $e_{m,i}$. If the code is check-regular, $\Sigma_m$ card( $\mathcal{N}$ (m)) = $M \cdot d_c$. In the second step, the extrinsic memory 104 for the subsequent iteration ($l$+1) may be updated using the $t_{m,i}$ according to

$$ e_{m,i}^{(l+1)} = 2 \cdot \tanh^{-1}\left( \prod_{j \in \mathcal{N}(m)\backslash\{i\}} \tanh\left(\frac{t_{m,j}}{2}\right) \right) \qquad \text{for all } i \in \mathcal{N}(m) $$

$$ = \left[ \prod_{j \in \mathcal{N}(m)\backslash\{i\}} \text{sign}\left(t_{m,j}\right) \right] \cdot \phi\left( \sum_{j \in \mathcal{N}(m)\backslash\{i\}} \phi\left(|t_{m,j}|\right) \right), \quad \text{with } \phi(\tau) = -\log\left( \tanh\left(\frac{\tau}{2}\right) \right) = \log\left(\frac{e^\tau + 1}{e^\tau - 1}\right) \qquad (3) $$

where the log-domain expression of the Sum-Product Algorithm (SPA) according to equation (3) may be more suitable for practical implementations, as the multiplication is replaced by an addition and instead of two functions $\tanh(\cdot)/\tanh^{-1}(\cdot)$, only a single function $\phi(\cdot)$ needs to be implemented (or approximated by a look-up table). The product (or the sum) of equation (3) may be carried out over all entries in $\mathcal{N}$ (m) except the one under consideration $i$. This is indicated by the notation $\mathcal{N}$ (m)\{i}. For instance, in the above example, where $\mathcal{N}(5) = \{1; 5; 9; 13; 21\}$, $e_{5,13}^{(l+1)}$ may be computed corresponding to

$$ e_{5,13}^{(l+1)} = 2 \cdot \tanh^{-1}\left( \prod_{j \in \mathcal{N}(5)\backslash\{13\}} \tanh\left(\frac{t_{m,j}}{2}\right) \right) = 2 \cdot \tanh^{-1}\left( \prod_{j \in \{1;5;9;21\}} \tanh\left(\frac{t_{m,j}}{2}\right) \right) $$

$$ = 2 \cdot \tanh^{-1}\left( \tanh\left(\frac{t_{5,1}}{2}\right) \tanh\left(\frac{t_{5,5}}{2}\right) \tanh\left(\frac{t_{5,9}}{2}\right) \tanh\left(\frac{t_{5,21}}{2}\right) \right). \qquad (4) $$

The derivation of equation (4) for the extrinsic update is beyond the scope of this specification. Usually, if high LDPC decoder throughputs shall be achieved, the computation of $e_{m,i}$ can be further simplified. An often employed simplification of the SPA log-domain equation (3), which we will consider in the following, is the so-called min-sum approximation or min-sum algorithm which leads to

$$ e_{m,i}^{(l+1)} = \left[ \prod_{j \in \mathcal{N}(m)\backslash\{i\}} \text{sign}(t_{k,j}) \right] \min_{j \in \mathcal{N}(m)\backslash\{i\}} |t_{m,j}| \qquad \text{for all } i \in \mathcal{N}(m). \qquad (5) $$

As the second act b) computes the output of the parity check node m of the check node in the graphical representation of LDPC codes, it is frequently denoted by check node operation 102. Hence, equation (5) may be denoted as min-sum check-node update operation having reduced complexity vis-à-vis the SPA check-node update operations of equation (3).

In the next decoding act c), the LLR memory may be updated corresponding to

$$\hat{z}_i = t_{m,i} + e_{m,i}^{(l+1)} \qquad \text{for all } i \in \mathcal{N}(m) \qquad\qquad (6)$$

and the LDPC decoder 100 may continue with decoding row $m+1$ or, if $m = M$, restarts at $m = 1$ (next iteration, $l + 1$).

Fig. 1 shows the simplified block diagram 100 of the min-sum check-node update operation for computing $e_{m,i}^{(l+1)}$ according to equation (5) for card($\mathcal{N}(m)$) = 4 (i.e., **H** contains for 1s at row m). As has been explained before, the check node operation 102 may be realized by equations (3) (log-domain SPA) or (5) (min-sum domain). Note that a routing network to access the different $\hat{z}_i$ (which are not necessarily stored in neighboring memory locations) is not shown in the Fig. 1.

The second step b), i.e., the check-node update, can be further simplified in actual implementations. Let $\mu_m^{[1]} = \min\limits_{j \in \mathcal{N}(m)} |t_{m,j}|$ be the first minimum of the absolute value of all involved incoming messages $t_{m,j}$ at row m and let $i_m^{[1]} = \arg\min\limits_{j \in \mathcal{N}(m)} |t_{m,j}|$ be the position (i.e., the index) of this first minimum. Let furthermore $\mu_m^{[2]} = \min\limits_{j \in \mathcal{N}(m) \setminus \{i_m^{[1]}\}} |t_{m,j}|$ be the second minimum (larger than the first minimum) of all incoming messages at row $m$. We further define $s_m = \prod\limits_{j \in \mathcal{N}(m)} \mathrm{sign}(t_{m,j})$. The output message can then be computed corresponding to

$$e_{m,i}^{(l+1)} = s_m \cdot \mathrm{sign}(t_{m,i}) \cdot \begin{cases} \mu_m^{[1]} & \text{if } i \neq i_m^{[1]} \\ \mu_m^{[2]} & \text{if } i = i_m^{[1]} \end{cases}. \qquad\qquad (7)$$

Note that equation (7) is an alternative representation of the min-sum check-node update operation of equation (5). Thus, one burden for implementing the check node operation 102 for computing $e_{m,i}^{(l+1)}$ consists in finding the first and second minimum of the incoming messages together with the position of the first minimum. The memory requirements of this algorithm are N memory cells for storing the (continuously updated) a-posteriori values $\hat{z}_i$. Additionally, the storing requirements of the extrinsic memory $e_{m,i}$ 104 amount to the total number of 1s in the parity check matrix **H**, however, due to the simplified implementation using the minimum approximation, the extrinsic memory 104 does not need to store all $d_c$ different values per row, but only the $d_c$ different signs, both minima $\mu_m^{[1]}$ and $\mu_m^{[2]}$, and the location index of the first minimum $i_m^{[1]}$. The values $e_{m,i}$ can then be computed on the fly as required.

As the min-sum algorithm according to equation (5) is only an approximation to the full belief-propagation expression of equation (3), numerous attempts have been made to improve the performance of the min-sum algorithm, i.e., the min-sum check-node update operation. One notable improvement is the so-called offset min-sum algorithm. The check-node update rule of the offset min-sum algorithm reads

$$e_{m,i}^{(l+1)} = s_m \cdot \mathrm{sign}(t_{m,i}) \cdot \begin{cases} \max(\mu_m^{[1]} - \beta, 0) & \text{if } i \neq i_m^{[1]} \\ \max(\mu_m^{[2]} - \beta, 0) & \text{if } i = i_m^{[1]} \end{cases}, \qquad\qquad (8)$$

where the offset correction variable $\beta$ can either be constant and determined offline or be updated during decoding according to a predefined rule.

While in the 1960s and the following decades, most coding research focused on block coding techniques, many practical coding schemes were based upon convolutional codes. With the advent of turbo codes and the rediscovery of LDPC codes, this suddenly changed such that nowadays most new coding schemes are again block codes. The trend is, however, to return back to convolutional-like structures.

In the last few years, the class of spatially coupled code ensembles has emerged and has shown to have appealing properties. LDPC convolutional codes, which are one particular instance of spatially coupled codes, have been around for more than a decade, but only recently it has been noticed that the belief propagation thresholds of certain (terminated) protograph-based LDPC convolutional codes approach the MAP thresholds of the underlying ensemble. Thus, contrary to a common belief, introducing structure into LDPC codes leads to a class of (degenerated) realizations of LDPC codes which show superior performance under belief propagation decoding. This effect of threshold saturation by introducing structure has been analyzed for the Binary Erasure Channel (BEC) and it has been shown that spatially coupled LDPC codes can asymptotically achieve the MAP threshold of the underlying regular ensemble under belief propagation decoding. Recently, this result has been extended to more general channels and it has been shown that spatially coupled ensembles universally achieve capacity over binary-input memoryless symmetric-output channels: most codes of this ensemble are good for each channel realization of this class of channels.

For simplicity, we exemplarily consider time-independent LDPC convolutional codes, but all embodiments can be extended to time-varying LDPC convolutional codes by introducing additional time indexing. Instead of being a block code of dimension N with parity-check matrix $\mathbf{H}$, a time-independent LDPC convolutional code has an infinitely extended parity-check matrix $\mathbf{H}_{conv}$, which has the following form

$$
\mathbf{H}_{conv} = \begin{pmatrix}
\ddots & & & & & \\
\ddots & \mathbf{H}_0 & & & & \\
\vdots & \mathbf{H}_1 & \mathbf{H}_0 & & & \\
\ddots & \vdots & \mathbf{H}_1 & \mathbf{H}_0 & & \\
\mathbf{H}_\mu & \vdots & \mathbf{H}_1 & \ddots & \\
& \mathbf{H}_\mu & \vdots & \ddots & \\
& & \mathbf{H}_\mu & \vdots & \\
& & & \ddots &
\end{pmatrix}_\infty .
$$

Thereby the value $\mu$ is commonly called the syndrome former memory, in analogy to convolutional codes. For simplicity only, we look in the remainder of this specification at the case $\mu = 1$, leading to

$$
\mathbf{H}_{conv} = \begin{pmatrix}
\ddots & & & & \\
\ddots & \mathbf{H}_0 & & & \\
& \mathbf{H}_1 & \mathbf{H}_0 & & \\
& & \mathbf{H}_1 & \mathbf{H}_0 & \\
& & & \mathbf{H}_1 & \ddots \\
& & & & \ddots
\end{pmatrix}_\infty .
$$

Note, however, that embodiments also comprise implementations with values of $\mu$ other than 1, e.g., $\mu = 0$ (leading to an LDPC block code) or $\mu > 1$. We see that $\dim(\mathbf{H}_0) = \dim(\mathbf{H}_1) = M \times N$ has to hold. Note that in practical systems, the code is usually terminated. For optical communication systems, which may usually be implemented in a stream-like mode, it is convenient to terminate the code only at the beginning of a transmission (or at the beginning of a super-frame) and thus we may consider left-terminated codes with the parity-check matrix

$$\mathbf{H}_{conv} = \begin{pmatrix} \mathbf{H}_0 & & & & & \\ \mathbf{H}_1 & \mathbf{H}_0 & & & & \\ & \mathbf{H}_1 & \ddots & & & \\ & & \ddots & \mathbf{H}_0 & & \\ & & & \mathbf{H}_1 & \mathbf{H}_0 & \\ & & & & \mathbf{H}_1 & \ddots \\ & & & & & \ddots \end{pmatrix}_{\infty}$$

This termination has a crucial effect on the performance and is responsible for the outstanding asymptotic performance of this class of codes.

Note that embodiments may also relate to time-dependent convolutional LDPC codes, which may be defined by a parity-check matrix

$$\mathbf{H}_{conv} = \begin{pmatrix} \ddots & & \ddots & & & \\ & \mathbf{H}_1(t-1) & \mathbf{H}_0(t-1) & & & \\ & & \mathbf{H}_1(t) & \mathbf{H}_0(t) & & \\ & & & \mathbf{H}_1(t+1) & \mathbf{H}_0(t+1) & \\ & & & & \ddots & \ddots \end{pmatrix}_{\infty}$$

The parity-check matrix of (time-dependent and time-independent) LDPC convolutional codes may be defined conveniently by a so-called row-defining matrix, which may be given by (in the most general case)

$$\mathbf{H}_{row}(t) = \begin{pmatrix} \mathbf{H}_{\mu}(t) & \cdots & \mathbf{H}_1(t) & \mathbf{H}_0(t) \end{pmatrix},$$

with dim $\mathbf{H}_{row}(t) = M \times (\mu+1)N$. The parity-check matrix $\mathbf{H}_{conv}$ of the convolutional LDPC code can be obtained by placing stacked copies of $\mathbf{H}_{row}(t)$ (with adapted time indices) that overlap by $\mu N$ columns. Time-independent LDPC convolutional codes may be constructed by a time-independent row-defining matrix $\mathbf{H}_{row}(t) = \mathbf{H}_{row}$. In the remainder of the specification we consider the example time-independent case $\mu = 1$. Embodiments can however be extended to larger values of $\mu$ and/or to time-dependent cases in a straight forward fashion.

Further, we consider a protograph-based construction of terminated spatially coupled (also commonly called terminated convolutional) LDPC codes. Thereby a protograph is a convenient way of describing certain sub-classes of LDPC codes. Protograph codes are constructed from a so-called $P$-cover of a relatively small graph which conveys the main properties of the code. The protograph serves as a blueprint for constructing LDPC codes of arbitrary size whose performance can be predicted by analyzing the protograph. A protograph can be any Tanner graph, typically one with a relatively small number of nodes. A protograph $G = (V, C, E)$ comprises a set of variable nodes $V$, a set of check nodes $C$, and a set of edges $E$. Each edge $e \in E$ connects a variable node $v_e \in V$ to a check node $c_e \in C$. Parallel edges are permitted, so the mapping $e \rightarrow (v_e, c_e) \in V \times C$ is surjective and thus not necessarily 1:1. This means that in contrast to the graph representation of the LDPC code, the protograph may contain multiple edges between variable and check nodes. The code itself is constructed by placing $P$ copies of the protograph next to each other (note that these have no interconnecting edges) and permuting the edges between the different copies of the protograph, such that the relation between the group of edges is respected.

This copy-and-permute operation for a protograph may be described by a protomatrix. An example of such a protomatrix is

$$\mathbf{B} = \begin{pmatrix} 1 & 2 & 0 \\ 2 & 1 & 3 \end{pmatrix}$$

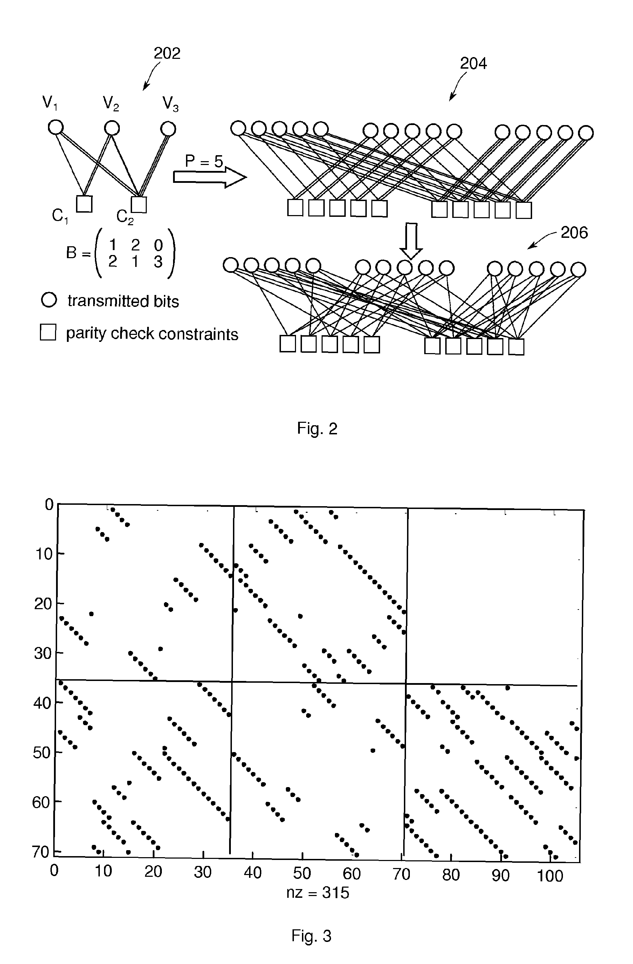

where the numbers or symbols in **B** denote the amount of parallel edges between the entries in the graph. Note that the permutation may be performed such that no parallel edges remain in the graph after permuting. **Fig. 2** shows an example of the copy-and-permute operation for generating a graph with $P=5$ using the example protomatrix **B**.

In Fig. 2, reference numeral 202 denotes a template graph, i.e., the protograph, for the protomatrix **B**. According to the entries of the first row of **B** there is one edge connecting variable node $v_1$ to check node $c_1$. Two edges are connecting variable node $v_2$ with check node $c_1$. Zero edges are between variable node $v_3$ and check node $c_1$. According to the entries of the second row of **B** there are two edges connecting variable node $v_1$ to check node $c_2$. One edge is connecting variable node $v_2$ with check node $c_2$. Three edges are between variable node $v_3$ and check node $c_2$. Reference numeral 204 denotes the graph resulting of the copy-operation with $P=5$ using protomatrix **B**. Finally, reference numeral 206 denotes the graph resulting of the permute-operation based on graph 204.

Most LDPC codes that are implemented today are so-called Quasi-Cyclic (QC) LDPC codes. They have a parity-check matrix **H** with a structure that allows for inherent paral-lelization of an LDPC decoder and leads to an efficient encoder realization. Almost all LDPC codes utilized in practice belong to the class of QC-LDPC codes.

QC-LDPC codes may be constructed using a so-called lifting matrix **A**. The parity-check matrix **H** may be constructed from the lifting matrix **A** by replacing each element of **A** with either an all-zero matrix of size $S{\times}S$ or a permutation matrix, e.g., a cyclically permuted identity matrix, of size $S{\times}S$. We adhere to the following notation: $S$ denotes the lifting factor, i.e., the size of the all-zero or cyclically shifted identity matrix. If the entry of **A** at row $m$ and column $i$ corresponds to a predetermined value, e.g., $A_{m,i} = -1$, then the all-zero matrix of size $S{\times}S$ is used, and if $A_{m,i} \geq 0$, $A_{m,i}$ may denote how many cyclic right shifts of the identity matrix are performed. If dim(**H**) = $M{\times}N$, then dim(**A**) = $M'{\times}N'$, with $M'=M/S$ and $N'=N/S$. We furthermore define the set $\mathcal{N}_{\mathbf{A}}(m)$ to denote the positions of the non "-1" entries (or any other entry denoting a void replacement) in the $m$-th row of A, i.e., $\mathcal{N}_{\mathbf{A}}(m)=\{i{:}A_{m,i}{\neq}i\text{-}1\}$.

Let us illustrate the construction of QC-LDPC codes by a small (artificial) example with a lifting matrix of size dim(A) = $3{\times}5$ and a lifting factor of $S$ = 5 (leading to dim(**H**) = $S{\cdot}$dim(**A**) = 15x25. This corresponds to a code of design rate $r$ = 0.4, or an overhead of 150%, respectively).

$$\mathbf{A} = \begin{pmatrix} -1 & 0 & 1 & 1 & 2 \\ 2 & -1 & 4 & 2 & 1 \\ 1 & 3 & -1 & 3 & 1 \end{pmatrix} \rightarrow \mathbf{H} = \begin{pmatrix} & & & & \\ & & & & \\ & & & & \end{pmatrix}$$

Note that for the sake of clarity again only non-zero entries are show in the description of **H**. Note that **H** represents a binary matrix. The extension to an $x$-ary matrix for higher-order modulation can be achieved by replacing the non-zero elements by according non-zero elements of GF($x$) or $\mathbb{Z}_x$. The selection of the ring of integer numbers modulo $x$ is also frequently used in coded modulation. Both $\mathbb{Z}_x$ and GF($x$) are identical if $x$ is prime. Generally the value S corresponds to the parallelism that can be implemented in a QC-LDPC decoder.

In order to realize protograph-based QC-LDPC codes, we may employ a double-lifting procedure. First, from the protomatrix **B**, we may generate by the copy-and-permute operation a lifting matrix **A** and then optimize the non-void entries of **A** in order to get desired code properties. Using this lifting matrix **A,** we can then construct the parity-check-matrix **H** with the desired properties. We thus have dim(**H**) = $M''SP \times N''SP$, with dim(**B**)=$M'' \times N''$.

Let us illustrate the generation of an exemplary parity-check matrix **H** of a protograph-based QC-LDPC based on two-fold lifting by means of an example with $P$=5 and $S$=7. We start with the same exemplary protomatrix

$$\mathbf{B} = \begin{pmatrix} 1 & 2 & 0 \\ 2 & 1 & 3 \end{pmatrix},$$

which has been already introduced above and illustrated in Fig. 2. One possible P=5 cover shown in Fig. 2 of the matrix **B** leads to a (parity-check) matrix **H**' that may be described by

$$\mathbf{H'} = \left( \begin{array}{ccccc|ccccc|ccccc} 1 & & & & & & & 1 & 1 & & & & & & \\ & & & & 1 & 1 & & & 1 & & & & & & \\ & & & 1 & & 1 & & & & 1 & & & & & \\ 1 & & & & & & 1 & & & 1 & & & & & \\ & & 1 & & & & & 1 & 1 & & & & & & \\ \hline 1 & & & & & 1 & & & 1 & & 1 & 1 & 1 & & \\ 1 & & & 1 & & & & & & 1 & & 1 & & 1 & 1 \\ & 1 & 1 & & 1 & & & & & & & & 1 & 1 & 1 \\ & 1 & & & 1 & & 1 & & & 1 & 1 & & 1 & & \\ & 1 & 1 & & & & & 1 & & 1 & & 1 & & & 1 \end{array} \right).$$

The bipartite graph 206 of the matrix **H**' is shown in the bottom right corner of Fig. 2. Note that the $P \times P$ squares of **H**' are filled with non-overlapping superpositions of permutation matrices preserving the number of "1"s per row and column of each $P \times P$ submatrix. Using the matrix **H**', we can get the lifting matrix **A** by properly selecting the cyclic shifts. An exemplary lifting matrix **A** is

$$\mathbf{A} = \left( \begin{array}{ccccc|ccccc|ccccc} -1 & 3 & -1 & -1 & -1 & -1 & 5 & 5 & -1 & -1 & -1 & -1 & -1 & -1 & -1 \\ -1 & -1 & -1 & -1 & 0 & 3 & -1 & -1 & 0 & -1 & -1 & -1 & -1 & -1 & -1 \\ -1 & -1 & -1 & 2 & -1 & 1 & -1 & -1 & -1 & 0 & -1 & -1 & -1 & -1 & -1 \\ 6 & -1 & -1 & -1 & -1 & -1 & 6 & -1 & -1 & 3 & -1 & -1 & -1 & -1 & -1 \\ -1 & -1 & 6 & -1 & -1 & -1 & -1 & 4 & 2 & -1 & -1 & -1 & -1 & -1 & -1 \\ \hline 0 & -1 & -1 & -1 & 0 & -1 & -1 & 2 & -1 & -1 & 5 & 4 & 6 & -1 & -1 \\ 4 & -1 & -1 & 1 & -1 & -1 & -1 & -1 & -1 & 1 & -1 & 2 & -1 & 0 & 5 \\ -1 & -1 & 1 & 0 & -1 & 0 & -1 & -1 & -1 & -1 & -1 & -1 & 6 & 6 & 6 \\ -1 & 4 & -1 & -1 & 0 & -1 & 4 & -1 & -1 & -1 & 2 & 0 & -1 & 6 & -1 \\ -1 & 2 & 1 & -1 & -1 & -1 & -1 & -1 & 5 & -1 & 0 & -1 & 0 & -1 & 3 \end{array} \right),$$

where the 1s of **H**' have been replaced by shift values in the range {0,1,...,$S$-1} (here $S$=7) and the 0s (not shown in the description of **H**' for clarity) have been replaced by "-1". The resulting exemplary parity-check matrix **H** has dimension $2PS \times 3PS$ = 70×105 and is visualized in Fig. 3, with the single dots representing the non-zero elements of the matrix.

In order to construct an exemplary spatially coupled protograph-based LDPC code used to achieve a channel utilization of approximately 0.8 bit/channel use with a 3-PSK modulation scheme, for example, we may generate exemplary $\mathbf{H}_0$ and $\mathbf{H}_1$ using the following exemplary protographs $\mathbf{B}_0$ and $\mathbf{B}_1$:

$$\mathbf{B}_0 = \begin{pmatrix} 2 & 1 \end{pmatrix}$$
$$\mathbf{B}_1 = \begin{pmatrix} 2 & 3 \end{pmatrix}$$

This may lead to the exemplary protograph $\mathbf{B}_{conv}$ defining an embodiment of a spatially coupled/convolutional LDPC code. Note that the right element of $\mathbf{B}_0$ is 1 in some embodiments.

$$\mathbf{B}_{conv} = \begin{pmatrix} 2 & 1 & & & & & & \\ 2 & 3 & 2 & 1 & & & & \\ & & 2 & 3 & 2 & 1 & & \\ & & & & 2 & 3 & 2 & 1 & \\ & & & & & & 2 & 3 & 2 & 1 \\ & & & & & & & \ddots & \ddots & \ddots & \ddots \end{pmatrix}$$

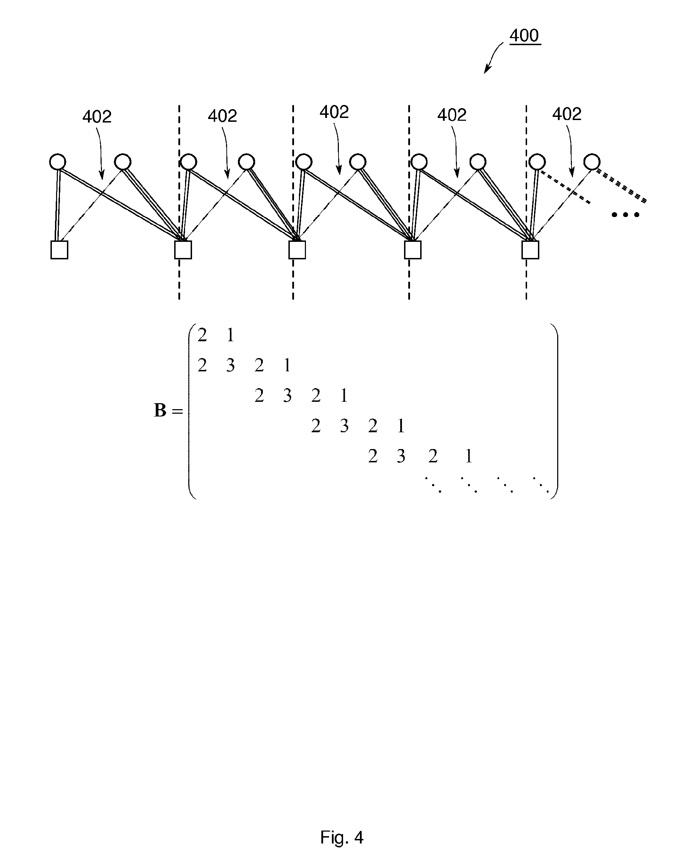

A protograph 400 corresponding to this exemplary protomatrix is shown in Fig. 4. The edges corresponding to the rightmost "1" in each row of the protomatrix $\mathbf{B}_{conv}$ are marked by dashed lines 402 in Fig. 4. The reason for this is the following: We do not permute these edges in the copy-and-permute operation and in the lifting process to generate the QC-code. We replace these edges corresponding to the rightmost "1" of each row in the protomatrix $\mathbf{B}_{conv}$ by an identity matrix. This structure may facilitate encoding.

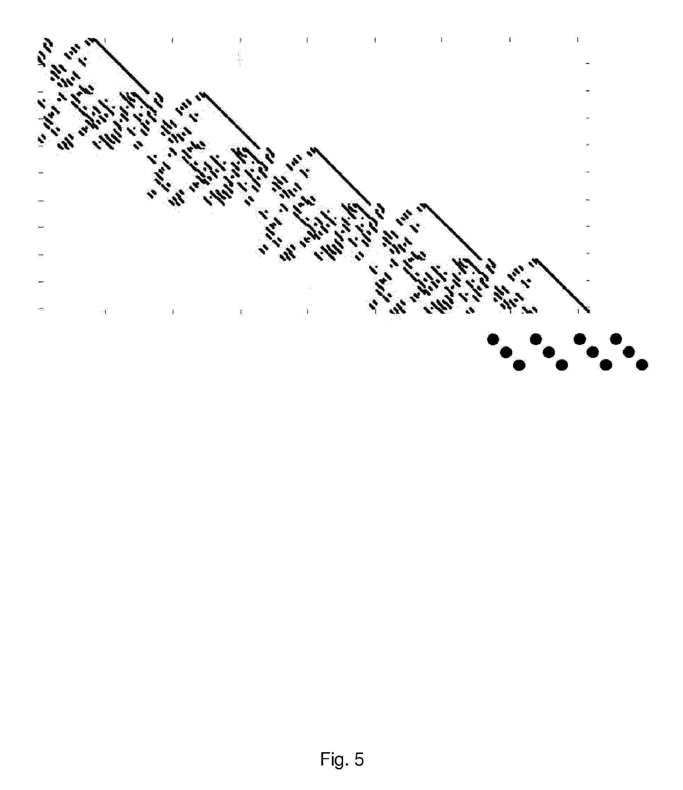

The resulting parity-check matrix for the parameters $P$=8 and $S$=512 is shown in **Fig. 5.** The matrix shown in Fig. 5 has been obtained by the protomatrix $\mathbf{B}_{conv}$ using the double lifting with $P$=8 and $S$=512 where the shifts have been optimized in order to avoid harmful structures that can lead to decoding failures. In addition, the "1" entry on the upper diagonal has not been lifted using random permutation matrices but using a simple identity matrix. This has the advantage that encoding is largely simplified. The encoding of the matrix based on this structure is described in the next step.

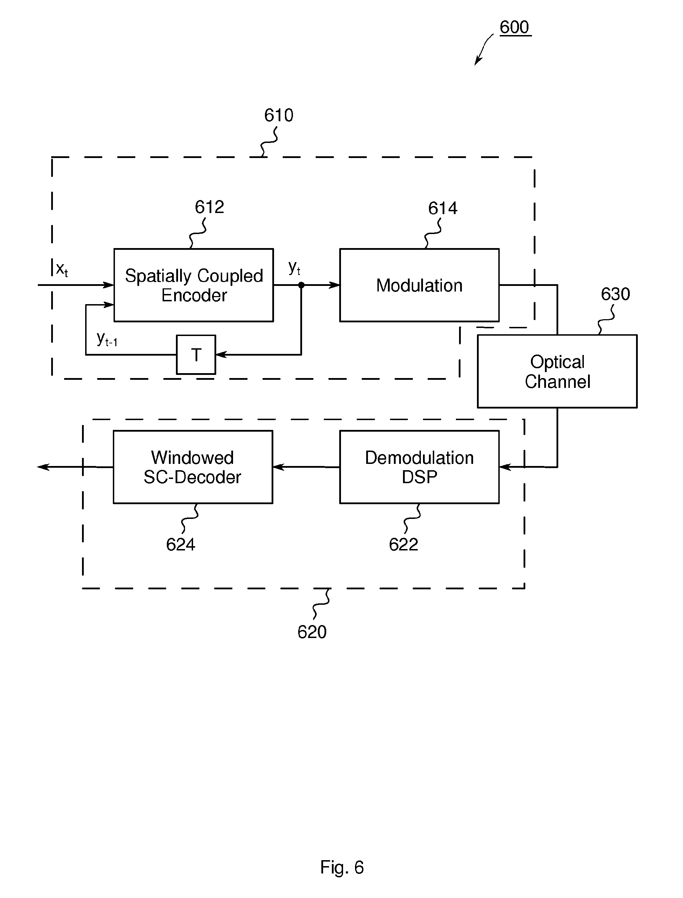

An encoder 612 for the LDPC convolutional code with $\mu = 1$ and parity check matrix $\mathbf{H}_{conv}$ is illustrated in the system model 600 of **Fig. 6.** The system model 600 comprises an optical transmitter 610 and receiver 622 connected via an optical channel 630, such as a fiber, for example. The optical communication channel 630 may also comprise additional inner digital signal processing stages, such as equalization, dispersion compensation, MIMO processing, phase offset estimation and correction, frequency offset estimation and correction, etc. The skilled person having benefit from the present disclosure will also appreciate that embodiments are not restricted to optical communication systems, but may also employed in other wired or wireless communication systems.

The LDPC convolutional encoder 612 encodes a block of information bits $\mathbf{x}_t$ (note that we include time indices to stress the dependence on previous frames) using $\mathbf{H}_0$ and $\mathbf{H}_1$ together with a previously encoded block $\mathbf{y}_{t-1}$ yielding $\mathbf{y}_t$. The size of each $\mathbf{y}_t$ amounts $N$, with $\dim(\mathbf{H}_0)=\dim(\mathbf{H}_1) = M \times N$. As $\mathbf{H}_0$ usually has a simple structure with a single identity matrix on the right hand part, encoding is rather trivial: each parity bit (with the position of the parity bit corresponding to the positions of the identity matrix) is directly given from the information bits $\mathbf{x}_t$ and the bits of the previously encoded block $\mathbf{y}_{t-1}$. We define $\mathbf{H}_0 = [\mathbf{H}_{0,s}\ \mathbf{I}]$ with $\mathbf{I}$ denoting the identity matrix and we define the sets

$$\mathcal{N}_1(m) = \{i : \mathrm{H}_{1,\mathrm{m,i}} \neq 0\}$$

$$\mathcal{N}_{0,s}(m) = \{i : \mathrm{H}_{0,\mathrm{s,m,i}} \neq 0\}$$

that contain the positions of the non-zero entries of $\mathbf{H}_0$ and $\mathbf{H}_{1,s}$ for row m, respectively. Let $\mathcal{N}_{1,i}$ (m) denote the $i$'th entry of $\mathcal{N}_1$ (m) and $\mathcal{N}_{0,s,i}$ (m) the $i$'th entry of $\mathcal{N}_{0,s}$ (m). The generation of parity bit $p_m$ ($1 \leq m \leq M$) can be described by

$$p_m \equiv \sum_i H_{1,m,\mathcal{N}_{1,i}(m)} y_{t-1,\mathcal{N}_{1,i}(m)} + \sum_j H_{0,s,m,\mathcal{N}_{0,s,j}(m)} x_{t,\mathcal{N}_{0,s,j}(m)} \bmod 2$$

Note that in principle every parity bit can be computed in parallel. At least S parity bits can be computed in parallel by fetching blocks of S data bits and respective shifter circuits.

The encoded block or frame $\mathbf{y}_t$ may be modulated using a modulator 614 to yield a block of modulated transmit symbols. The modulated transmit symbols are then transmitted to the receiver 620 via the communication channel 630, which may be an optical communication channel in some embodiments. A demodulator 622 may extract reliability information, e.g. LLRs, for each symbol or bit of a received encoded block or frame.

Spatially coupled or LDPC convolutional codes may be decoded using a sliding window decoder 624 to recover the information sequences. The decoder 624 may operate on a window of $w$ copies of the row defining matrix $\mathbf{H}_{row}$ corresponding to a window of ($w+\mu$) frames of reliability information. For faster convergence speed, the windowed decoding can be combined with the aforementioned row-decoding or layered decoding algorithm. Note that example embodiments are not limited to the use of the layered decoding scheme but also other decoding schemes may be employed, which do not use an explicit a-posteriori memory. For example, a conventional flooding decoder does not need an a-posteriori memory, but rather needs extrinsic edge memories that play a similar role. The layered decoder continuously updates and refines the received reliability information (e.g. LLR values) in the decoding window with the goal to compute LLRs that approximate the MAP values.

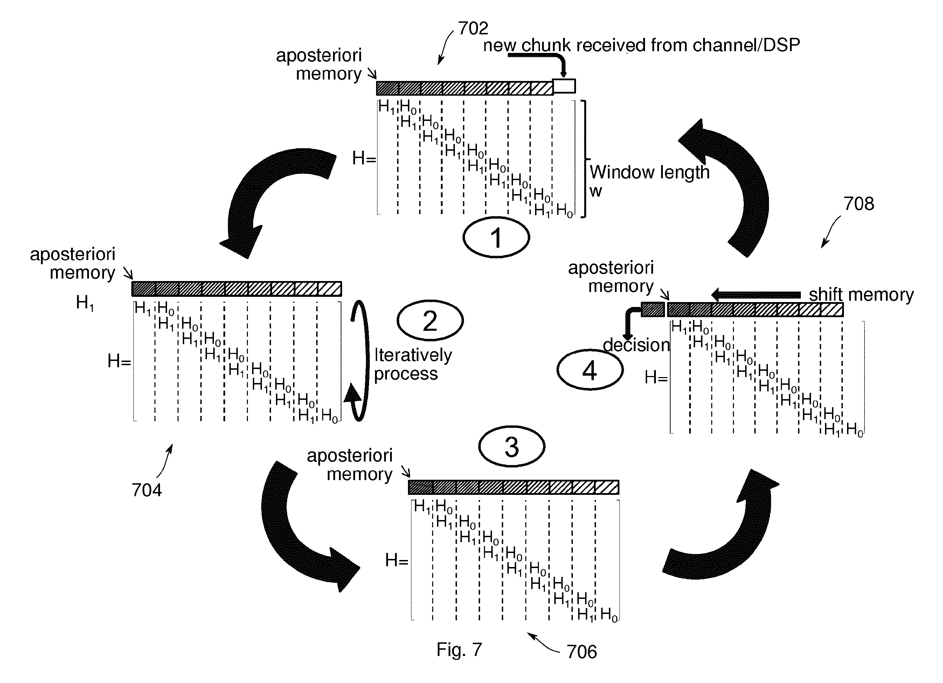

Four exemplary cycles of the windowed decoder 624 are depicted in **Fig. 7** for an example with window size $w = 8$. The example windowed decoder 624 makes use of an a-posteriori memory of size $(w+\mu)N$, with $N$ = columns($\mathbf{H}_0$) = columns($\mathbf{H}_1$) = N"SP.

In a first act 702 of the illustrated cycle a new chunk or frame (size $N$) of received reliability information, e.g. LLRs, at time instant $t$ is received and inserted into an appropriate position (for example an input portion) of an a-posteriori memory of the decoder 624. In a second act 704, a predefined number V of layered decoder iterations may be executed making use of the row defining matrix $\mathbf{H}_{row}$. Note that the row decoder algorithm can be designed for this matrix $\mathbf{H}_{row}$ and then can be reused by just accessing appropriately shifted memory locations. In case of the windowed decoder 624 the previously described decoding algorithms may be applied to the whole reliability information window as LLR memory in a straight-forward fashion.

The different shades of grey in a third act 706 (as well as in the other steps) indicate reliabilities of different frames of received LLRs in the decoders's a-posteriori memory. It can be observed that the reliabilities increase from right to left, i.e., the oldest values having received the highest number of updates, have the largest reliability. In a fourth act 708 of the cycle, the decoder's a-posteriori memory is shifted and the left-most LLR frame (for example in an output portion of the a-posteriori memory) may be forwarded to a hard decision circuit in order to recover hypothetically transmitted symbols. After the shifting, there is now room for a new frame that can be inserted into the input portion in the first act 702 of the next cycle.

Note that the version of the windowed decoding algorithm described above introduces a decoding delay of $w+\mu$-1 frames, such that at time instant $t$, we can recover the information frame $\mathbf{x}'_{t-w-\mu+1}$. This is however of no issue in an optical communication system operating in a streaming fashion. Note that at the beginning an LDPC convolutional like encoder may be initialized with zeros at its input dedicated to the delayed version $\mathbf{y}_{t-1}$ of the encoded output signal $\mathbf{y}_t$. Hence, in the case of LDPC convolutional encoders the two inputs to the encoder at time instant $t$ may be an input signal $\mathbf{x}_t$ (to be encoded) as well as the delayed (encoded) output signal $\mathbf{y}_{t-1}$ (and, if $\mu > 1$, $\mathbf{y}_{t-1}$, ..., $\mathbf{y}_{t-\mu}$). If the transmission starts at $t = 0$, this means that we set $\mathbf{y}_{-1} = \mathbf{0}$. Accordingly, the memory of the decoder 624 may be initialized with perfect knowledge about the initial symbols being zero ($+\infty$ or the corresponding maximum value in the case of a fixed point implementation). Usually, after a certain amount of frames denoted by $L$ (i.e., at $t = L$), the transmission may be reset to prevent error propagation and the decoder/encoder pair is brought into the initial stage again. Note that this termination may lead to an unavoidable rate loss but is crucial for the outstanding performance of spatially coupled codes.

In future and current optical communication systems, high decoding throughputs in the order of several 100 Gbit/s are usually required. In order to achieve these throughputs, the underlying architecture usually imposes severe constraints on the number of iterations $V$ the windowed decoder 624 is able to carry out. Already with $V = 1$ and a window size w in the order of 10 to 15, good performance results can be obtained which may out-perform state-of-the art block LDPC codes. With larger numbers *V* of iterations, the performance may be further improved, however at the expense of an increased hardware complexity. Further note that in some applications, e.g., optical long-haul communications, a continuous data flow is required. This continuous data flow has to be fed continuously to upper layers of the communication system. This continuous data flow and the absence of a return channel limits the use of advanced algorithms including hybrid Automatic Repeat Request (ARQ) or the use of more iterations until decoding convergence is obtained. In the time when more iterations are carried out, no continuous data-flow may be realized.

Embodiments suggest modifying the conventional windowed decoder concept, which has been described above. By an additional control mechanism, the shifting phase of the windowed decoder can be controlled. If, by an error detection mechanism in example embodiments, a current frame in the output portion of the windowed decoder is not properly decoded, the shifting phase is not executed, such that at the next execution, the windowed decoder operates on the same data, which can be understood as an additional iteration being executed on that part of the data.

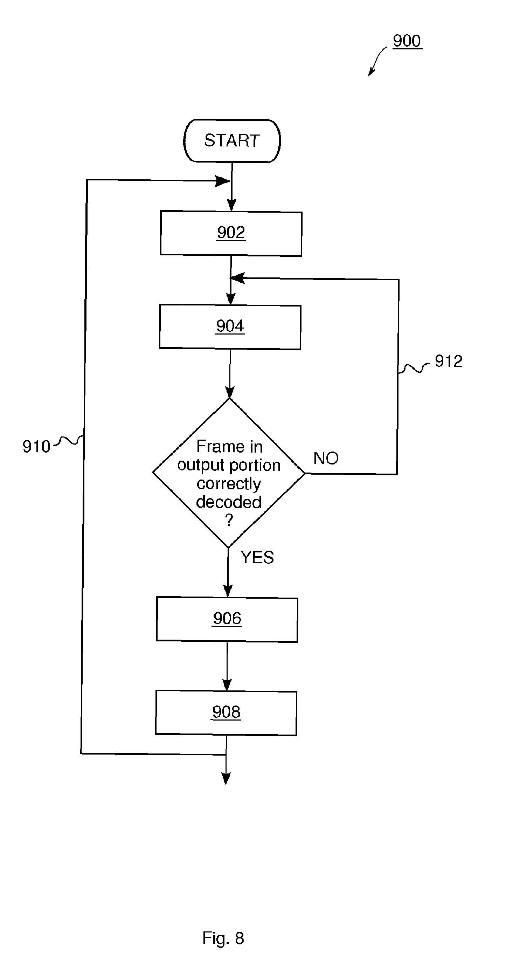

**Fig. 8** illustrates a schematic flow-chart of a method 900 for decoding an encoded signal. The encoded signal is encoded with an LDPC convolutional code having a parity check matrix **H.**

The decoding method 900 comprises an act 902 of providing a new frame of reliability information of the encoded signal to an input portion of a window of reliability information (of a windowed decoder). Further, the method comprises an act 904 of executing a number of decoding iterations using the part of the parity check matrix **H** and the window of reliability information. If a frame of reliability information in an output portion of the window of reliability information has been correctly decoded, the method 900 comprises further acts of forwarding 906 the frame from the output portion to a hard decision entity, shifting 908 the remaining frames of reliability information in the window toward the output portion, and returning (see reference numeral 910) to act 902.

As can be seen from Fig. 8, acts 906, 908 are not performed in example embodiments, if the frame of reliability information in the output portion has not been decoded correctly. A further criterion may be that a maximum number of iterations or decoding rounds has not yet been reached. In this case (see reference numeral 912) an additional number of decoding iterations may be performed using the part of the parity check matrix **H** and the same window of reliability information without the provision of a new frame of reliability information to the input portion of the windowed decoder.

As explained before, the LDPC convolutional code's parity check matrix H may be composed of at least one row defining matrix $\mathbf{H}_{row}(t)=(\mathbf{H}_\mu(t) \cdots \mathbf{H}_1(t)\ \mathbf{H}_0(t))$. For time dependent LDPC convolutional codes, there may be more than one row defining matrix, of course. The row defining matrix $\mathbf{H}_{row}$ may comprise $(\mu+1)$ parity check submatrices $\mathbf{H}_0$, $\mathbf{H}_1$, $\mathbf{H}_\mu$, wherein $\mu$ denotes the LDPC convolutional code's syndrome former memory. In some embodiments, the windowed decoder may operate on a window of $(w+\mu)$ frames of reliability information stored in an a-posteriori memory of the decoder. Hence, act 902 may include providing the new frame of reliability information of the encoded signal into an input portion of the reliability information memory or a-posteriori memory. In example implementations, act 904 may include executing a predefined additional number V of decoding iterations using the row defining matrix $\mathbf{H}_{row}$ and the $(w+\mu)$ frames of reliability information stored in the decoder's reliability information memory. If a frame of reliability information in an output portion of the decoder's reliability information memory has been correctly decoded, act 906 may include forwarding at least said frame from the reliability information memory's output portion to the hard decision entity. Act 908 may include shifting the remaining $(w+\mu-1)$ frames of reliability information in the reliability information memory toward the output portion of the reliability information memory such that a new frame may be inserted into the reliability information memory's input portion.

In one or more embodiments inserting 902 the newly received frame into the decoder's input portion may include transferring said frame from an upstream located ingress buffer to the input portion. Likewise, the act 906 of forwarding the frame from the decoder's output portion may comprise transferring said frame from the output portion to a downstream located egress buffer. Here, the term "upstream" refers to an entity which is located before another entity in the signal flow. Likewise, the term "downstream" refers to an entity which is located after another entity in the signal flow.

Hence, one idea of example embodiments is to surround the windowed decoder by two First-In First-Out (FIFO) buffers at its input and output, denoted in the following as ingress FIFO and egress FIFO. By an additional control mechanism, the shifting phase of the windowed decoder may be controlled. If, by an error detection mechanism, the current frame in the decoder's output portion is not properly decoded, the shifting phase (act c) may not be executed, such that at the next execution, the windowed decoder may operate on the same data, which can be understood as additional iteration(s) being executed on that part of the data. The ingress and egress FIFO buffers may ensure a continuous data flow together with the control unit, as will be explained in the following.

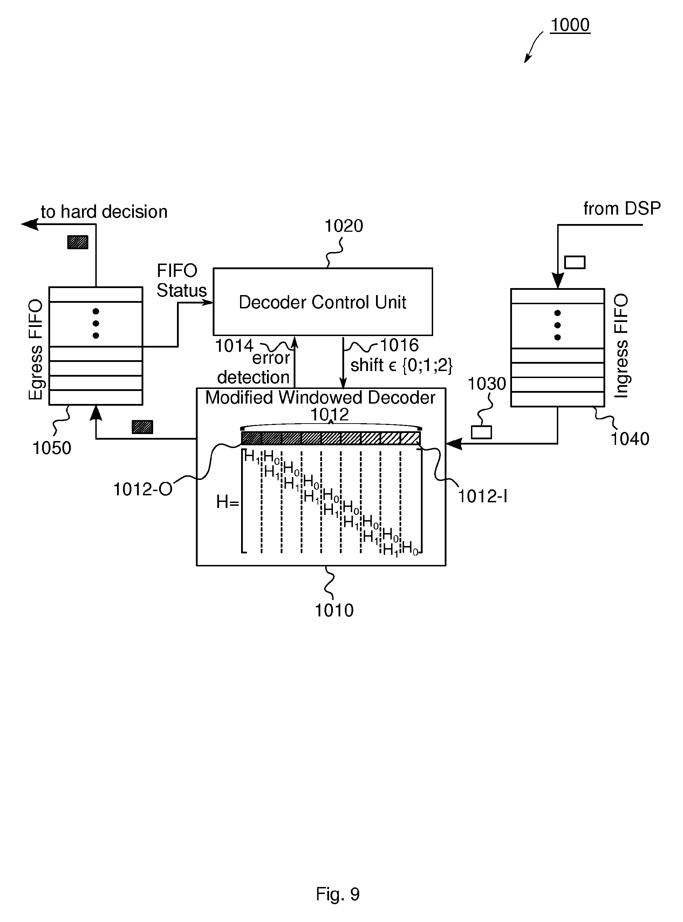

An example embodiment of an apparatus 1000 for decoding an LDPC convolutional encoded signal is depicted in **Fig. 9.**

The apparatus 1000 comprises a windowed decoder 1010 and a control unit 1020. The control unit 1020 is configured to provide a new frame 1030 of reliability information of the encoded signal to an input portion 1012-I of a window 1012 of reliability information. The windowed decoder 1010 is configured to execute a possibly predefined number V of decoding iterations using the part of the parity check matrix **H** corresponding to the window 1012 of reliability information. The decoder control unit 1020 is configured to determine whether a frame of reliability information in an output portion 1012-O of the decoder's window 1012 has been correctly decoded. If the frame in the output portion 1012-O has been correctly decoded, the control unit 1020 causes forwarding said frame from the output portion 1012-O to a hard decision entity (not shown), shifting the remaining frames of reliability information in the window 1012 toward the output portion 1012-O, and providing a new frame 1030 of reliability information to the now vacant input portion 1012-I of the decoding window 1012. However, if the frame has not been decoded correctly, example embodiments of the control unit 1020 may be configured to keep said frame in the decoder's output portion 1012-O and to cause an additional number V of decoding iterations using the part of the parity check matrix **H** and the same window of reliability information as in the previous number of iterations.

Optionally, the apparatus 1000 may also comprise an ingress FIFO buffer 1040 and an egress FIFO buffer 1050. The ingress buffer 1040 may be coupled to the input portion 1012-I of the decoding window or the reliability information memory (for example, a-posteriori memory) 1012. The egress buffer 1050 may be coupled to the output portion 1012-O of the reliability information memory. The ingress buffer 1040 may be configured to store a predetermined number of incoming frames of the encoded signal, while the egress buffer 1050 may be configured to store a predetermined number of decoded frames. At the beginning of each decoding phase ($t$ = 0, $t$ = $L$, $t$ = $2L$, ...) the ingress FIFO buffer 1040 may be emptied, while the egress buffer 1050 may be filled with $M_B$ dummy frames (e.g., the all-zero frame), $M_B$ denoting a maximum size of the buffers, respectively. The transmission may thus start with an empty ingress buffer 1040 and with a full ($M_B$ entries) egress buffer 1050. In some embodiments, the size of the ingress buffer 1040 may equal the size of the egress buffer 1050.

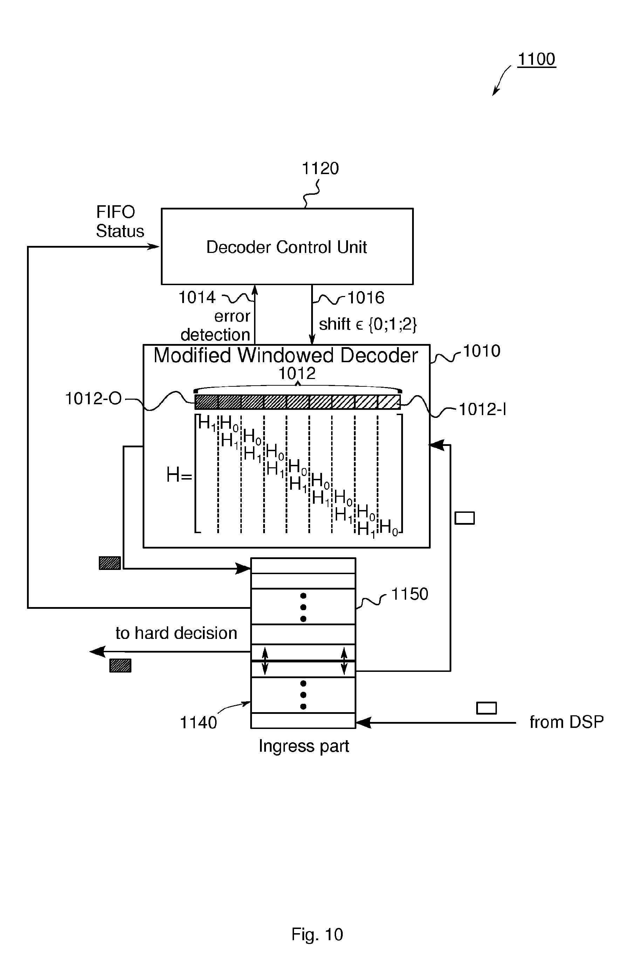

Note that the number of frames in the ingress and egress FIFO 1040, 1050 may be a constant number and amount to $M_B$. This means that in some embodiments both FIFO buffers 1040, 1050 may be replaced by a single memory comprising $M_B$ frames with variable read and write addresses. This alternative implementation is depicted in **Fig. 10,** where the egress and ingress FIFO buffers 1050, 1040 of Fig. 9 are combined into a single memory with variable writing and reading addresses selected by the control unit 1120. The single memory thereby comprises an ingress portion 1140 and an egress portion 1150. The ingress portion 1140 and the egress portion 1150 together have capacity for $M_B$ frames.

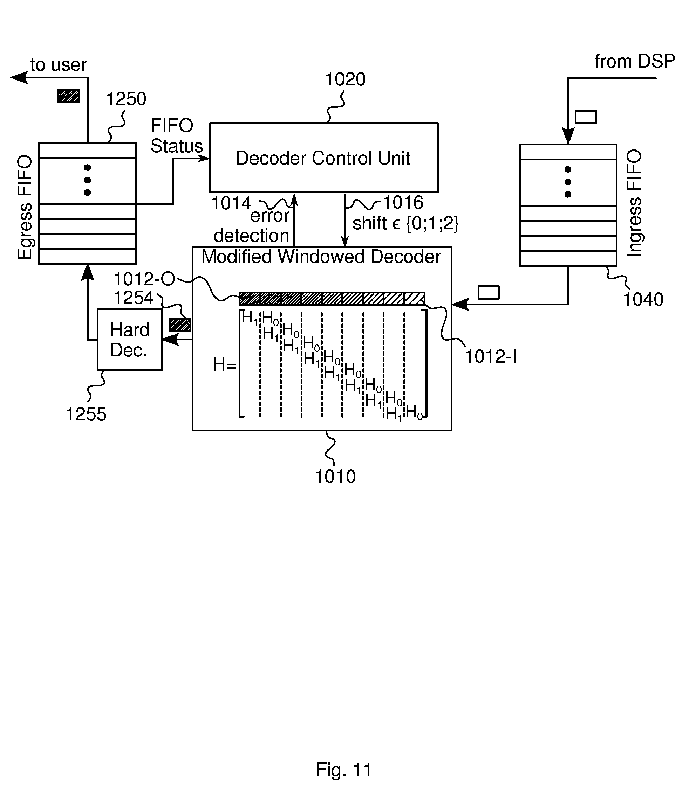

In an alternative implementation it may also be possible to carry out the hard decision on a forwarded frame 1254 before entering the egress FIFO, as shown in **Fig. 11.** Here, the output portion 1012-O of the decoder 1010 is coupled to a hard decision entity 1255 for converting the soft reliability information (e.g. LLRs) of the output frame 1254 to hard decisions (e.g. bits). In such embodiments the egress FIFO 1250 may simplify to a binary FIFO.

Note that the modified windowed decoder according to the example embodiments of Figs. 10 to 12 may have an additional input 1016 and an additional output 1014. The additional input 1016 may be dedicated to a variable ("*shift*") describing if the windowed decoder 1010 carries out the shifting act 908 or not. For example, if "*shift*=0", the shifting act 908 is not carried out and the decoder 1010 does not output a chunk/frame at the current time instant (and of course cannot accept a new chunk in the next execution $t$+1). This situation may be covered by the two FIFOs 1040, 1050, 1140, 1150, or 1240, 1250 which may ensure that a continuous data stream is sustained. Setting shift to zero (*shift*=0) may effectively correspond to increasing the number of iterations carried out on the current number of chunks in the window or reliability information memory 1012 by V ($V$= 1, 2, 3, 4, ...). This means that this situation shall be enforced if errors prevail in the memory 1012 after the first decoding round.

In order to assess the presence of possible decoding errors in the data, example embodiments of the modified decoder 1010 may also comprise error detection circuitry. The error detection circuitry may indicate by an additional Boolean output the presence of an error in the upcoming decision, such that another decoding round (act 904) can be triggered. If the Boolean output "*shift* > 0" (e.g., *shift* = 2 = σ, which may be equal to $\mu$+1 in some embodiments), then the a posteriori memory 1012 may be shifted by σ = 2 chunks of reliability information and correspondingly σ = 2 output chunks may be written into the egress FIFO buffer 1050 while in the first act 902 of the next decoding round, σ = 2 new chunks have to be fetched from the ingress buffer 1040. That is to say, in some embodiments the control unit 1020 is configured to determine whether σ frames of reliability information samples in an output portion of the reliability information memory 1012 have been correctly decoded. If the σ frames in the output portion have been correctly decoded, the control unit 1020 may be configured to forward the σ frames from the output portion to a hard decision entity, to shift the remaining frames of reliability information in the reliability information memory toward the output portion of the reliability information memory, and to insert σ new frames of reliability information into an input portion of the reliability information memory.

Several embodiments for realizing the error detection can be implemented. In the case of spatially coupled LDPC codes the parity check matrix **H** may immediately enable error detection. By taking the hard decisions of the soft reliability information memory entries (e.g., LLRs) and multiplying them with the (part of the) parity check matrix **H** under consideration, an error may be detected if the result is not the all-zero vector. As the reliabilities of the entries in the decoder's a posteriori memory 1012 are not constant, it is not necessary to use the complete window, but for instance only the first row [$H_1$ $H_0$] (or [$H_\mu$, $H_{\mu-1}$,...$H_0$]) and the corresponding $\mu$+1 chunks/frames in the decoder's a posteriori memory 1012. If the result is the all-zero vector, we can infer that the $\mu$+1 left-most chunks, i.e., the oldest chunks, which are the two most reliable chunks, in the reliability information memory 1012 are error-free such that "*shift*=2" can be selected and σ can be set to any of the values σ = 2,3...,$\mu$+1 (in the example with $\mu$=1, σ=2 is the only admissible value). Of course, more lines of the parity check matrix **H** (and thus more chunks) can be checked for errors allowing for shift values larger than 2. In this case one should bear in mind that the reliabilities of the chunks decrease and the error detection will indicate errors even if the left-most chunk in the output portion 1012-O is error free.

In an alternative implementation, an embodiment may use the binary decision of a previously decided frame already forwarded to the egress FIFO buffer 1050 or some other memory location to perform error detection. That is to say, in some embodiments the control unit 1020 may be configured to compute one or more parity check equations using hard decisions on reliability information of an already forwarded frame and at least a portion of the parity check matrix **H** of the LDPC convolutional code. The error detection may be performed using the row defining matrix [$H_\mu$, $H_{\mu-1}$,...$H_0$] with the previously decided frame and the left-most and thus most reliable chunk(s) in the memory 1012. In this case, a more reliable decision for setting "*shift*=1" can be taken, for example. Note that for setting "*shift*=2", the two left-most chunks in the reliability information memory may need to be taken into account, such that in this setting two distinct error detections may be performed.

For another example, an embodiment may also perform error detection by use of an outer algebraic code, e.g., a Cyclic Redundancy Check (CRC) or a Bose-Chaudhuri-Hocquenghem (BCH) code, which may be applied to a complete chunk in the memory 1012, e.g., to its systematic bits. In this case one can immediately see if a single chunk in the memory 1012 is error free and does not need to rely on the fact that always two or more chunks are detected in parallel by the aforementioned parity-check matrix approach. This approach may lead however to a coding rate penalty, but error detection may be carried out with a finer granularity.

In the remainder of this disclosure, we assume that the error detection is generated according to the first exemplary embodiment and signals the error status of the most reliable or oldest σ chunks of the decoder's reliability information memory 1012.

The control unit 1020 may control the number of shifts to be carried out based on the error detection information and/or the fill level of the FIFO buffers 1040, 1050. As both FIFO buffers 1040, 1050 may work synchronously only the fill level of one of them may be required. We assume that the fill level of the egress FIFO 1050 and/or the ingress FIFO 1040 is coupled to the control unit 1020. In some embodiments the control unit 1020 may be configured to forward a frame from the window's output portion 1012-O to the egress buffer 1050, even if said frame has not been decoded correctly, when a maximum storage capacity of the ingress buffer 1040 or a maximum number of iterations has been reached.

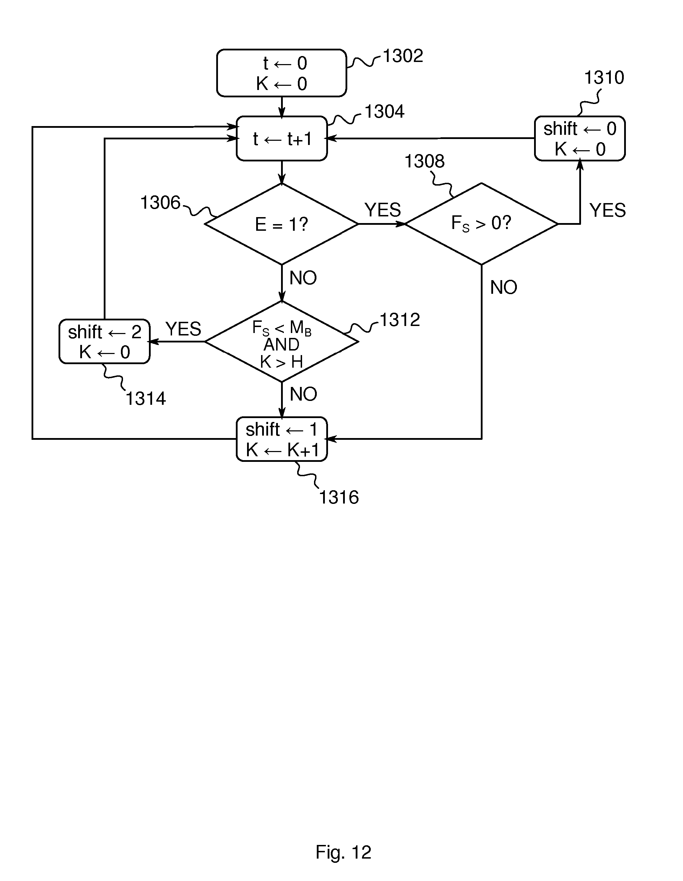

One example way to implement the control unit 1020 is by means of a state machine. One possible state machine is illustrated in **Fig. 12.**

In Fig. 12 some additional variables have been introduced. Let $F_S$ denote the fill level of the egress FIFO 1050 with $F_S$ taking possible values between 0 and $M_B$. Let E denote the error state returned by the error detection unit of the windowed decoder 1010, with $E = 1$ denoting a detected error. We have additionally introduced a counting variable $K$, a frame counter index $t$, and a hysteresis constant $H$, which prevents the control unit 1020 to shift by σ = 2 immediately after shift=0 has been selected, i.e., additional iterations have been carried out. With this approach the disturbed data inside the decoding window 1012 gets more opportunities to be corrected by the decoder (additional $H$ iterations) before being shifted out of the window.

In an initial act 1302 the state machine initializes frame counter index $t$ and counting variable K by zero, respectively. In a further act 1304 the state machine increments frame counter index $t$ by 1. If the error state $E$ returned by the error detection unit of the windowed decoder 1010 equals one (see reference numeral 1306) and the fill level $F_S$ of the egress FIFO 1050 is larger than zero (see reference numeral 1308), than *shift* and counting variable $K$ are set to zero (see reference numeral 1310) before incrementing 1304 frame counter index $t$ by 1. If the error state E returned by the error detection unit of the windowed decoder 1010 equals one (see reference numeral 1306) and the fill level $F_S$ of the egress FIFO 1050 is zero (see reference numeral 1308), than *shift* is set to one and counting variable $K$ is incremented by one (see reference numeral 1316) before incrementing 1304 frame counter index $t$ by one. If the error state $E$ returned by the error detection unit of the windowed decoder 1010 equals zero (see reference numeral 1306), the fill level $F_S$ of the egress FIFO 1050 is smaller than $M_B$, and the counting variable $K$ is larger than hysteresis constant $H$ (see reference numeral 1312), than *shift* is set to two and counting variable $K$ is set to zero (see reference numeral 1314) before incrementing 1304 frame counter index $t$ by 1. If in act 1312 the fill level $F_S$ of the egress FIFO 1050 equals $M_B$, and/or the counting variable $K$ is smaller than or equal to the hysteresis constant $H$, than *shift* is set to one and counting variable $K$ is incremented by one (see reference numeral 1316) before incrementing 1304 frame counter index $t$ by one.

Note that embodiments may cause an additional decoding delay by $M_B$ frames on top of the delay by $w+\mu-1$ caused already by the windowed decoder. Also note that embodiments are not constrained to the use of the windowed decoding scheme presented herein, but can use any decoder that operates in a windowed scheme, i.e., accepts frames at a time instant $t$ and generates an estimated decoding output of that same frame at output $t+w'$ by operating on a portion (a window) of the parity-check matrix **H** of the convolutional LDPC code.

We quantify the possible gains in a typical simulation example. We consider two spatially coupled codes $C_1$ and $C_2$. The code $C_1$ is defined by the protographs $B_{1,0}$ and $B_{1,1}$ with $B_{1,0}$ = (2 2 2 2) and $B_{1,1}$ = (1 1 1 1). The parity check matrices for code $C_1$ are generated using the two-fold lifting operation described above with $P$ = 72 and $S$ = 40. The code $C_2$ is defined by the protographs $B_{2,0}$ and $B_{2,1}$ with $B_{2,0}$ = (2 2 2 2) and $B_{2,1}$ = (2 2 2 2). The parity check matrices for code $C_2$ are generates using the two-fold lifting operation described above with $P$ = 24 and $S$ = 40. The rates of both codes are 0.8 which corresponds to an FEC overhead of 25%. We employ windowed decoding with window size $w$ = 12 frames and we select the FIFO buffer size to be $M_B$ = 5 and the hysteresis constant to $H$ = 4. We have reset the decoder after each $L$=500 time instants.

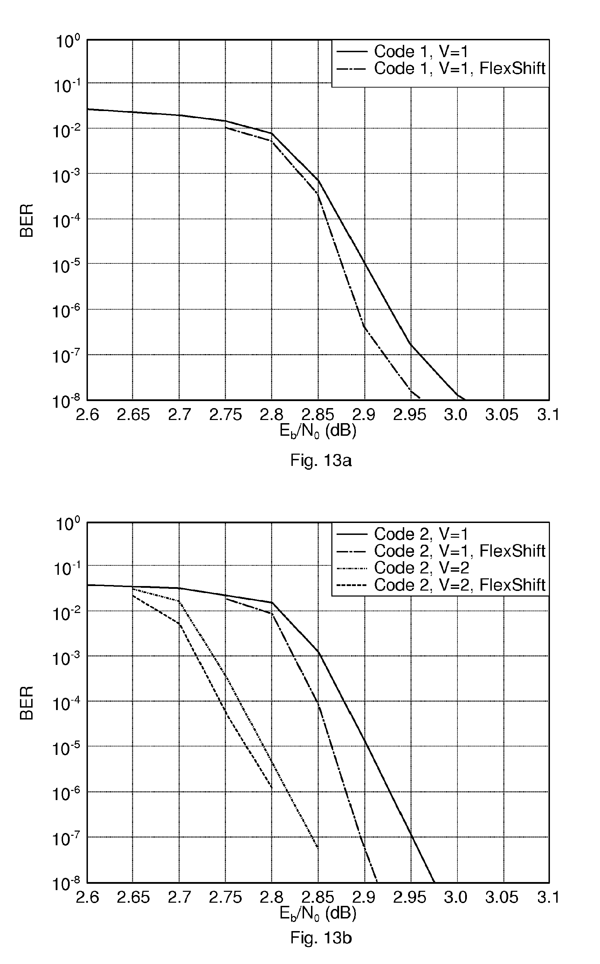

**Figures 13a and 13b** show the performance comparison for both codes $C_1$ and $C_2$ using a simulation with BPSK modulation over an AWGN channel. One can see that especially for $V$ = 1 noteworthy performance improvements can be achieved without significantly increasing the decoding complexity. The proposed approach merely increases the amount of required memory and introduces a small additional decoding delay depending on the buffer size.

Example embodiments may increase the coding gain (and lower the error floor) for high throughput optical transceivers without increasing the decoding complexity significantly, i.e., with a low-complexity decoder.

The description and drawings merely illustrate the principles of the invention. It will thus be appreciated that those skilled in the art will be able to devise various arrangements that, although not explicitly described or shown herein, embody the principles of the invention and are included within its spirit and scope. Furthermore, all examples recited herein are principally intended expressly to be only for pedagogical purposes to aid the reader in understanding the principles of the invention and the concepts contributed by the inventor(s) to furthering the art, and are to be construed as being without limitation to such specifically recited examples and conditions. Moreover, all statements herein reciting principles, aspects, and embodiments of the invention, as well as specific examples thereof, are intended to encompass equivalents thereof.

Functional blocks shall be understood as functional blocks comprising circuitry that is adapted for performing a certain function, respectively. Hence, a "module or entity for s.th." may as well be understood as a "module or entity being adapted or suited for s.th.". A module or entity being adapted for performing a certain function does, hence, not imply that such means necessarily is performing said function (at a given time instant).

Functions of various elements shown in the figures, including any functional blocks may be provided through the use of dedicated hardware, such as "a processor", "a controller", etc. as well as hardware capable of executing software in association with appropriate software. Moreover, any entity described herein as functional block, may correspond to or be implemented as "one or more modules", "one or more devices", "one or more units", etc. When provided by a processor, the functions may be provided by a single dedicated processor, by a single shared processor, or by a plurality of individual processors, some of which may be shared. Moreover, explicit use of the term "processor" or "controller" should not be construed to refer exclusively to hardware capable of executing software, and may implicitly include, without limitation, digital signal processor (DSP) hardware, network processor, application specific integrated circuit (ASIC), field programmable gate array (FPGA), read only memory (ROM) for storing software, random access memory (RAM), and non-volatile storage. Other hardware, conventional and/or custom, may also be included.

It should be appreciated by those skilled in the art that any block diagrams herein represent conceptual views of illustrative circuitry embodying the principles of the invention. Similarly, it will be appreciated that any flow charts, flow diagrams, state transition diagrams, pseudo code, and the like represent various processes which may be substantially represented in computer readable medium and so executed by a computer or processor, whether or not such computer or processor is explicitly shown.

Furthermore, the following claims are hereby incorporated into the Detailed Description, where each claim may stand on its own as a separate embodiment. While each claim may stand on its own as a separate embodiment, it is to be noted that - although a dependent claim may refer in the claims to a specific combination with one or more other claims - other embodiments may also include a combination of the dependent claim with the subject matter of each other dependent claim. Such combinations are proposed herein unless it is stated that a specific combination is not intended. Furthermore, it is intended to include also features of a claim to any other independent claim even if this claim is not directly made dependent to the independent claim.

It is further to be noted that methods disclosed in the specification or in the claims may be implemented by a device having means for performing each of the respective steps of these methods.

Further, it is to be understood that the disclosure of multiple steps or functions disclosed in the specification or claims may not be construed as to be within the specific order. Therefore, the disclosure of multiple steps or functions will not limit these to a particular order unless such steps or functions are not interchangeable for technical reasons. Furthermore, in some embodiments a single step may include or may be broken into multiple sub steps. Such sub steps may be included and part of the disclosure of this single step unless explicitly excluded.

**Claims**

1. A method (900) for decoding an encoded signal, the encoded signal being encoded with an LDPC convolutional code having a parity check matrix, the method comprising:

   a) providing (902) a new frame (1030) of reliability information of the encoded signal to an input portion (1012-I) of a window (1012) of reliability information;
   b) executing (904) a number of decoding iterations using a part of the parity check matrix and the window (1012) of reliability information; and
   if a frame (1254) of reliability information in an output portion (1012-O) of the window (1012) of reliability information has been correctly decoded,
   c) forwarding said frame (1254) from the output portion (1012-O) to a hard decision entity, shifting the remaining frames of reliability information in the window (1012) toward the output portion (1012-O), and returning to act a).

2. The method (900) of claim 1, wherein act c) is not performed, if the frame of reliability information in the output portion (1012-O) of the window (1012) has not been decoded correctly.

3. The method (900) of claim 2, wherein an additional number of decoding iterations is performed using the part of the parity check matrix and the same window (1012) of reliability information.

4. The method (900) of claim 1, wherein inserting the new frame (1030) into the input portion (1012-I) of the window (1012) of reliability information comprises
   transferring said frame (1030) from an ingress buffer (1040) to the input portion (1012-I), and
   wherein forwarding the decoded frame (1254) comprises
   transferring said decoded frame (1254) from the output portion (1012-O) of the window (1012) of reliability information to an egress buffer (1050).

5. The method (900) of claim 4, wherein act c) is performed, even if the frame (1254) in the output portion (1012-O) has not been decoded correctly, if a maximum capacity of the ingress buffer (1040) for storing frames of reliability information of the encoded signal is reached.

6. The method (900) of claim 4, wherein a size of the ingress buffer equals a size of the egress buffer.

7. The method (900) of claim 1, wherein determining whether the frame (1254) in the output portion (1012-O) of the window (1012) of reliability information has been correctly decoded comprises
   computing one or more parity check equations using hard decisions on reliability information of said frame (1254) and at least a portion of the parity check matrix of the LDPC convolutional code.

8. The method (900) of claim 4, wherein determining whether the frame (1254) in the output portion (1012-O) of the window (1012) of reliability information has been correctly decoded comprises
   computing parity check equations using hard decisions on reliability information of said frame (1254), hard decisions of a previously decoded frame in the egress buffer (1050), and a portion of the LDPC convolutional code's parity check matrix corresponding to said frame and the previously decoded frame.

9. The method (900) of claim 4, comprising
   before inserting the new frame (1030) of reliability information into the input portion (1012-I) of the of the window (1012), receiving said new frame via an optical communication channel and storing it in the ingress buffer (1040).

10. A computer-program for performing the decoding method (900) of claim 1, when the computer-program is executed on a programmable hardware device.

11. An apparatus (1000) for decoding an encoded signal, the encoded signal being encoded with an LDPC convolutional code having a parity check matrix, the apparatus comprising:

    a control unit (1020) to provide a new frame (1030) of reliability information of the encoded signal to an input portion (1012-I) of a window (1012) of reliability information;
    a windowed decoder (1010) to execute a number of decoding iterations using a part of the parity check matrix and the window (1012) of reliability information;

wherein the control unit (1020) is configured

to determine whether a frame (1254) of reliability information in an output portion (1012-O) of the window (1012) has been correctly decoded and,

if the frame (1254) in the output portion (1012-O) has been correctly decoded,

to forward said frame (1254) from the output portion (1012-O) to a hard decision entity, to shift the remaining frames of reliability information in the window (1012) toward the output portion (1012-O), and

to provide a new frame of reliability information into the input portion (1012-I) of the window (1012).

12. The apparatus (1000) of claim 11, wherein the control unit (1020) is configured to keep said frame (1254) in the output portion (1012-O) of the window (1012) of reliability information and to cause the windowed decoder (1010) to execute an additional number of decoding iterations using the part of the parity check matrix and the window (1012) comprising the same frames of reliability information, if the frame has not been decoded correctly.

13. The apparatus (1000) of claim 11, further comprising

an ingress buffer (1040) coupled to an input portion (1012-I) of a memory for the window (1012) of reliability information; and

an egress buffer (1050) coupled to an output portion (1012-O) of the memory,

wherein the ingress buffer (1040) is configured to store a maximum number of incoming frames of the encoded signal, and

wherein the egress buffer (1050) is configured to store said maximum number of decoded frames.

14. The apparatus (1000) of claim 13, wherein the control unit (1020) is configured to forward a frame from the output portion (1012-O) to the egress buffer (1050), even if said frame has not been decoded correctly, when a maximum storage capacity of the ingress buffer (1040) or a maximum number of decoding iterations is reached.

15. The apparatus (1000) of claim 11, wherein the control unit (1020) is configured to determine whether two or more frames of reliability information samples in the output portion (1012-O) of the window (1012) of reliability information have been correctly decoded, and,

if the two or more frames in the output portion have been correctly decoded,

to forward the two or more frames from the output portion (1012-O) to the hard decision entity, to shift the remaining frames of reliability information in the window (1012) toward the output portion (1012-O) of the window (1012), and to insert two or more new frames of reliability information into the input portion (1012-I) of the window (1012).

**Amended claims in accordance with Rule 137(2) EPC.**

1. A method (900) for decoding an encoded signal, the encoded signal being encoded with an LDPC convolutional code having a parity check matrix, the method comprising:

   a) providing (902) a new frame (1030) of reliability information of the encoded signal from an ingress buffer (1040) for storing a maximum number of incoming frames of the encoded signal to an input portion (1012-I) of a window (1012) of reliability information;
   b) executing (904) a number of decoding iterations using a part of the parity check matrix and the window (1012) of reliability information; and
   if a frame (1254) of reliability information in an output portion (1012-O) of the window (1012) of reliability information has been correctly decoded,
   c) forwarding said frame (1254) from the output portion (1012-O) to a hard decision entity, wherein forwarding the decoded frame (1254) comprises transferring said decoded frame (1254) from the output portion (1012-O) of the window (1012) of reliability information to an egress buffer (1050) for storing the maximum number of decoded frames,
   shifting the remaining frames of reliability information in the window (1012) toward the output portion (1012-O), and
   returning to act a),
   wherein act c) is not performed, if the frame of reliability information in the output portion (1012-O) of the window (1012) has not been decoded correctly, and wherein act c) is performed, even if the frame (1254) in the output portion (1012-O) has not been decoded correctly, if the maximum number of frames in the ingress buffer (1040) is reached or if the egress buffer (1050) is empty.

2. The method (900) of claim 1, wherein act c) comprises forwarding two or more frames of reliability information from the output portion (1012-O) to the egress buffer (1050), if

   i) the two or more frames of reliability information have been correctly decoded, and
   ii) the maximum number of frames in the egress buffer (1050) has not been reached, and
   iii) a number of previously forwarded single frames is larger than a predefined hysteresis constant.

3. The method (900) of claim 1, wherein, if act c) is not performed, a number ($K$) of previously forwarded single frames is set to zero (1310).

4. The method (900) of claim 1, wherein, if act c) comprises forwarding two or more frames, a number ($K$) of previously forwarded single frames is set to zero (1314).

5. The method (900) of claim 1, wherein, if act c) comprises forwarding a single frame, a number ($K$) of previously forwarded single frames is incremented by one (1316).

6. The method (900) of claim 1, wherein an additional number of decoding iterations is performed using the part of the parity check matrix and the same window (1012) of reliability information.

7. The method (900) of claim 1, wherein a size of the ingress buffer equals a size of the egress buffer.

8. The method (900) of claim 1, wherein determining whether the frame (1254) in the output portion (1012-O) of the window (1012) of reliability information has been correctly decoded comprises
   computing one or more parity check equations using hard decisions on reliability information of said frame (1254) and at least a portion of the parity check matrix of the LDPC convolutional code.

9. The method (900) of claim 1, wherein determining whether the frame (1254) in the output portion (1012-O) of the window (1012) of reliability information has been correctly decoded comprises
   computing parity check equations using hard decisions on reliability information of said frame (1254), hard decisions of a previously decoded frame in the egress buffer (1050), and a portion of the LDPC convolutional code's parity check matrix corresponding to said frame and the previously decoded frame.

10. The method (900) of claim 1, comprising
    before inserting the new frame (1030) of reliability information into the input portion (1012-I) ofthe ofthe window (1012), receiving said new frame via an optical communication channel and storing it in the ingress buffer (1040).

11. A computer-program for performing the decoding method (900) of claim 1, when the computer-program is executed on a programmable hardware device.

12. An apparatus (1000) for decoding an encoded signal, the encoded signal being encoded with an LDPC convolutional code having a parity check matrix, the apparatus comprising:

    an ingress buffer (1040) configured to store a maximum number of incoming frames of the encoded signal;
    an egress buffer (1050) configured to store the maximum number of decoded frames;
    a control unit (1020) to provide a new frame (1030) of reliability information of the encoded signal to an input portion (1012-I) of a window (1012) of reliability information, wherein the control unit (1020) is configured to provide the new frame (1030) to the input portion (1012-I) by transferring said frame (1030) from the ingress buffer (1040) to the input portion (1012-I);
    a windowed decoder (1010) to execute a number of decoding iterations using a part of the parity check matrix and the window (1012) of reliability information;
    wherein the control unit (1020) is configured
    to determine whether a frame (1254) of reliability information in an output portion (1012-O) ofthe window (1012) has been correctly decoded and,
    if the frame (1254) in the output portion (1012-O) has been correctly decoded,
    to forward said frame (1254) from the output portion (1012-O) to a hard decision entity, wherein the control unit (1020) is configured to forward the frame (1254) by transferring said decoded frame (1254) from the output portion (1012-O) of the window (1012) of reliability information to the egress buffer (1050),
    to shift the remaining frames of reliability information in the window (1012) toward the output portion (1012-O), and

to provide a new frame of reliability information into the input portion (1012-I) of the window (1012), wherein the control unit (1020) is configured to keep said frame (1254) in the output portion (1012-O) of the window (1012) of reliability information and to cause the windowed decoder (1010) to execute an additional number of decoding iterations using the part of the parity check matrix and the window (1012) comprising the same frames of reliability information, if the frame has not been decoded correctly, wherein the control unit (1020) is configured to forward a frame from the output portion (1012-O) to the egress buffer (1050), even if said frame has not been decoded correctly, when a maximum number of frames in the ingress buffer (1040) is reached or when the egress buffer (1050) is empty.

13. The apparatus (1000) of claim 12, wherein the control unit (1020) is configured to determine whether two or more frames of reliability information samples in the output portion (1012-O) of the window (1012) of reliability information have been correctly decoded, and,
if the two or more frames in the output portion have been correctly decoded,
to forward the two or more frames from the output portion (1012-O) to the hard decision entity, to shift the remaining frames of reliability information in the window (1012) toward the output portion (1012-O) of the window (1012), and to insert two or more new frames of reliability information into the input portion (1012-I) of the window (1012).

14. The apparatus (1000) of claim 13, wherein the control unit (1020) is configured to forward the two or more frames, if

i) the maximum number of frames in the egress buffer (1050) has not been reached (1254), and
ii) a number of previously forwarded single frames is larger than a predefined hysteresis constant.

15. The apparatus (1000) of claim 12, wherein the control unit (1020) is configured to set a number ($K$) of previously individually forwarded frames is set to zero (1310), if

i) no frame is forwarded from the output portion (1012-O) to the egress buffer (1050), or if
ii) two or more frames are forwarded from the output portion (1012-O) to the egress buffer (1050)
and wherein the control unit (1020) is configured to increment a number of previously forwarded single frames by one, if a single frame is forwarded from the output portion (1012-O) to the egress buffer (1050).

$\hat{Z}_i$

100

102

$e_{m,i}^{(l+1)}$

**Check Node Operation**

$$e_{m,i} = \prod_{j \in N(m)\backslash\{i\}} \text{sign}(t_{m,j}l) \min_{j \in N(m)\backslash\{i\}} |t_{m,j}l| \ , \ \forall i \ \epsilon \ N(m)$$

Extrinsic
Memory $e_{m,i}$

104

$t_{m,i}$

$e_{m,i}^{(l)}$

$\hat{Z}_i$

Fig. 1

Fig. 2

nz = 315

Fig. 3

$$B = \begin{pmatrix} 2 & 1 & & & & & & \\ 2 & 3 & 2 & 1 & & & & \\ & & 2 & 3 & 2 & 1 & & \\ & & & & 2 & 3 & 2 & 1 \\ & & & & & 2 & 3 & 2 & 1 \\ & & & & & & \ddots & \ddots & \ddots & \ddots \end{pmatrix}$$

Fig. 4

Fig. 5

600

610

612

$|x_t$

Spatially Coupled
Encoder

$y_t$

614

Modulation

630

$y_{t-1}$

T

Optical
Channel

Windowed
SC-Decoder

Demodulation
DSP

624

622

620

Fig. 6

Fig. 7

EP 2 911 304 A1

900

START

902

904

912

910

Frame in
output portion
correctly
decoded
?

NO

YES

906

908

Fig. 8

Fig. 9

Fig. 10

Fig. 11

Fig. 12

Fig. 13a

Fig. 13b

Europäisches
Patentamt

European
Patent Office

Office européen
des brevets

# EUROPEAN SEARCH REPORT

Application Number

EP 14 30 5248

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2013/254633 A1 (OBATA HARUKA [JP] ET AL) 26 September 2013 (2013-09-26) * the whole document * | 1-15 | INV. H03M13/11 |
| A | US 2013/139025 A1 (GIOULEKAS FOTIOS [GR] ET AL) 30 May 2013 (2013-05-30) * the whole document * | 1-15 | |
| A | BATES S ET AL: "A Low-Cost Serial Decoder Architecture for Low-Density Parity-Check Convolutional Codes", IEEE TRANSACTIONS ON CIRCUITS AND SYSTEMS I: REGULAR PAPERS, IEEE, US, vol. 55, no. 7, 1 August 2008 (2008-08-01) , pages 1967-1976, XP011333172, ISSN: 1549-8328, DOI: 10.1109/TCSI.2008.918002 * the whole document * | 1-15 | |

TECHNICAL FIELDS
SEARCHED      (IPC)

H03M

The present search report has been drawn up for all claims

| Place of search | Date of completion of the search | Examiner |
|---|---|---|
| Munich | 16 June 2014 | Offer, Elke |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

& : member of the same patent family, corresponding
    document

EPO FORM 1503 03.82 (P04C01)

## ANNEX TO THE EUROPEAN SEARCH REPORT
## ON EUROPEAN PATENT APPLICATION NO.

EP 14 30 5248

This annex lists the patent family members relating to the patent documents cited in the above-mentioned European search report.
The members are as contained in the European Patent Office EDP file on
The European Patent Office is in no way liable for these particulars which are merely given for the purpose of information.

16-06-2014

| Patent document cited in search report | Publication date | Patent family member(s) | Publication date |
|---|---|---|---|
| US 2013254633 A1 | 26-09-2013 | JP 2013198017 A<br>US 2013254633 A1 | 30-09-2013<br>26-09-2013 |
| US 2013139025 A1 | 30-05-2013 | NONE | |

EPO FORM P0459

For more details about this annex : see Official Journal of the European Patent Office, No. 12/82